# EUROPEAN PATENT SPECIFICATION

(11) **EP 3 130 458 B1**
(45) Date of publication and mention of the grant of the patent: **17.07.2019**
(21) Application number: 15764176.2
(22) Date of filing: 18.03.2015
(51) Int. Cl.: H05B 33/04, H05B 33/20, H01L 33/52, C09D 7/40, B32B 27/00, B32B 7/12, C09D 1/00

(54) **ELECTRONIC DEVICE**
ELEKTRONISCHE VORRICHTUNG
DISPOSITIF ÉLECTRONIQUE

(30) Priority: 18.03.2014 JP 2014054968; 13.08.2014 JP 2014164639; 13.08.2014 JP 2014164643
(43) Date of publication of application: 15.02.2017
(73) Proprietor: Kuraray Co., Ltd., Okayama 710-0801 (JP)
(72) Inventor: SASAKI, Ryoichi, Kurashiki-shi Okayama 713-8550 (JP); INUBUSHI, Yasutaka, Kurashiki-shi Okayama 713-8550 (JP); NAKAYA, Masakazu, Kurashiki-shi Okayama 713-8550 (JP); TAKAI, Jun, Tsukuba-shi Ibaraki 305-0841 (JP); ARIMOTO, Kikuo, Tsukuba-shi Ibaraki 305-0841 (JP); OTA, Masahiko, Kurashiki-shi Okayama 713-8550 (JP); MORIHARA, Yasushi, Kurashiki-shi Okayama 713-8550 (JP)
(74) Representative: Müller-Boré & Partner Patentanwälte PartG mbB
(86) International application number: PCT/JP2015/001529
(87) International publication number: WO 2015/141226

(56) References cited:
- EP-A2- 1 942 084
- EP-A2- 2 584 623
- WO-A1-2011/122036
- WO-A1-2013/051288
- WO-A1-2013/187064
- WO-A1-2013/187064
- GB-A- 1 411 592

## Description

### TECHNICAL FIELD

The present invention relates to electronic devices. The present invention more particularly relates to an electronic device including a protective sheet including a multilayer structure including a base (X) and a layer (Y) stacked on the base (X). The present invention also relates to a fluorescent quantum dot-containing electronic device including a protective sheet including a multilayer structure including a base (X) and a layer (Y) stacked on the base (X).

### BACKGROUND ART

Composite structures having a gas barrier layer containing aluminum have conventionally been proposed for use in electronic devices such as a liquid crystal display of a display device, and examples of the composite structures include a composite structure having a transparent gas barrier layer composed of a product of reaction between aluminum oxide particles and a phosphorus compound (see Patent Literature 1).

Patent Literature 1 discloses a method for forming the gas barrier layer, in which a coating liquid containing aluminum oxide particles and a phosphorus compound is applied onto a plastic film, followed by drying and heat treatment.

However, the above conventional gas barrier layer may suffer from defects such as cracks and pinholes when exposed to physical stresses such as deformation and impact, and may thus fail to maintain sufficient gas barrier properties over a long period of time.

In recent years, electronic devices such as a light-emitting diode (LED) have increasingly employed quantum dots as a fluorescent material that converts the wavelength of incident light and emits the wavelength-converted light. A quantum - dot (QD) is a light-emitting semiconductor nanoparticle and typically has a diameter on the order of 1 to 20 nm. In the quantum dot, electrons are quantally confined within a three-dimensional, sharply-outlined, nanoscale semiconductor crystal. Such fluorescent quantum dots are prone to aggregation and can be degraded, for example, by oxygen, for which reason they are generally dispersed in a medium such as a resin when used.

Patent Literature 2 describes a flash module in which quantum dots are dispersed in a matrix composed of polymethylmethacrylate (PMMA), polystyrene, polycarbonate, sol-gel, UV-curable resin, or thermosetting resin such as epoxy resin.

Even when fluorescent quantum dots are dispersed in a resin, however, they may be degraded, for example, by oxygen or water contained in air.

Patent Literature 3 describes a multilayer structure used as protection sheet for flexible electronic devices, the multilayer structure providing gas and water barrier properties.

### CITATION LIST

### Patent Literature

Patent Literature 1: JP 2003-251732 A
Patent Literature 2: JP 2006-114909 A
Patent Literature 3: WO 2013/187064 A

### SUMMARY OF INVENTION

### Technical Problem

It is an object of the present invention to provide an electronic device that includes a protective sheet highly resistant to physical stresses and superior in gas barrier properties and water vapor barrier properties. It is also an object of the present invention to provide an electronic device that includes a multilayer structure superior in gas barrier properties and water vapor barrier properties and that suffers less degradation during long-term use in air. The term "gas barrier properties" as used herein refers to the ability to function as a barrier against gases other than water vapor, unless otherwise specified. The simpler term "barrier properties" as used herein collectively refers to both gas barrier properties and water vapor barrier properties.

### Solution to Problem

As a result of a detailed study, the present inventors have completed the present invention by finding that the above objects can be achieved by an fluorescent quantum dot-containing electronic device covered by a multilayer structure including a particular layer.

The present invention is an electronic device including an electronic device body 1 and a protective sheet 3 covering the surface of the electronic device body 1. The protective sheet 3 includes a multilayer structure including a base (X) and a layer (Y) stacked on the base (X). The layer (Y) includes a metal oxide (A), a phosphorus compound (B), and cations (Z) with an ionic charge (Fz) of 1 or more and 3 or less. The phosphorus compound (B) includes a compound containing a moiety capable of reacting with the metal oxide (A). In the layer (Y), the number of moles (N_{M}) of metal atoms (M) constituting the metal oxide (A), the number of moles (Np) of phosphorus atoms derived from the phosphorus compound (B), the number of moles (Nz) of the cations (Z), and the ionic charge (Fz) of the cations (Z) satisfy a relationship of 0.8 ≤ N_{M}/N_{P} ≤ 4.5. In the layer (Y), the number of moles (N_{M}), the number of moles (N_{Z}) of the cations (Z), and the ionic charge (F_{Z}) of the cations (Z) satisfy a relationship of 0.001 ≤ F_{Z} × N_{Z}/N_{M} ≤ 0.60. The combination of these features makes it possible to provide an electronic device that suffers less degradation by oxygen or water contained in air.

The cations (Z) include at least one selected from the group consisting of lithium ions, sodium ions, potassium ions, magnesium ions, calcium ions, titanium ions, zirconium ions, lanthanoid ions, vanadium ions, manganese ions, iron ions, cobalt ions, nickel ions, copper ions, zinc ions, boron ions, aluminum ions, and ammonium ions. The metal atoms (M) comprise at least one selected from the group consisting of aluminum, titanium, and zirconium.

The electronic device may include fluorescent quantum dots.

The protective sheet may be placed on one side or both sides of a layer containing the fluorescent quantum dots.

In the layer (Y), the number of moles (N_{M}), the number of moles (N_{Z}), and the ionic charge (F_{Z}) may satisfy a relationship of 0.01 ≤ F_{Z} × N_{Z}/N_{M} ≤ 0.60.

In the layer (Y), at least part of the phosphorus compound (B) has reacted with the metal oxide (A). The phosphorus compound (B) may include at least one selected from the group consisting of phosphoric acid, polyphosphoric acid, phosphorous acid, phosphonic acid, phosphonous acid, phosphinic acid, phosphinous acid, and derivatives thereof.

In an infrared absorption spectrum of the layer (Y), a maximum absorption wavenumber in a region of 800 to 1,400 cm⁻¹ may be 1,080 to 1,130 cm⁻¹.

The base (X) may include a thermoplastic resin film.

The layer (Y) may include a polymer (C) containing at least one functional group selected from the group consisting of a carbonyl group, a hydroxy group, a carboxyl group, a carboxylic anhydride group, and a salt of a carboxyl group.

In the electronic device of the present invention, the multilayer structure may further include a layer (W) placed contiguous to the layer (Y). The layer (W) may include a polymer (G1) having a functional group containing a phosphorus atom.

The polymer (G1) may be poly(vinylphosphonic acid) or poly(2-phosphonooxyethylmethacrylate).

The electronic device according to the present invention may be produced by:
a step [I] of mixing a metal oxide (A), a phosphorus compound (B) containing a moiety capable of reacting with the metal oxide (A), and an ionic compound (E) containing cations (Z) with an ionic charge (F_{Z}) of 1 or more and 3 or less, so as to prepare a first coating liquid (U);
a step [II] of applying the first coating liquid (U) onto the base (X) to form a precursor layer of the layer (Y) on the base (X); and
a step [III] of heat-treating the precursor layer at a temperature of 110°C or higher.

In the first coating liquid (U), the number of moles (N_{M}) of metal atoms (M) constituting the metal oxide (A) and the number of moles (N_{P}) of phosphorus atoms derived from the phosphorus compound (B) may satisfy a relationship of 0.8 ≤ N_{M}/N_{P} ≤ 4.5. In the first coating liquid (U), the number of moles (N_{M}), the number of moles (N_{Z}) of the cations (Z), and the ionic charge (F_{Z}) may satisfy a relationship of 0.001 ≤ F_{Z} × N_{Z}/N_{M} ≤ 0.60.

### Advantageous Effects of Invention

According to the present invention, it is possible to obtain an electronic device including a protective sheet highly resistant to physical stresses and superior in gas barrier properties and water vapor barrier properties. According to the present invention, it is also possible to obtain an electronic device that includes a protective sheet superior in gas barrier properties and water vapor barrier properties and that suffers less degradation during long-term use in air. According to the present invention, it is further possible to obtain a fluorescent quantum dot-containing electronic device that includes a protective sheet superior in gas barrier properties and water vapor barrier properties and that suffers less degradation and successfully retains its performance even after long-term use (light emission for 2,000 consecutive hours, for example) in air.

### BRIEF DESCRIPTION OF DRAWINGS

FIG. 1 is a partial cross-sectional view of an electronic device according to an embodiment of the present invention.
FIG. 2 is a cross-sectional view showing an example of a light-emitting device in which a fluorescent quantum dot-containing composition according to the first embodiment of the present invention is used in at least a part of a sealing member.
FIG. 3 is a cross-sectional view showing a light-emitting device in which a fluorescent quantum dot-dispersed resin shaped product according to the first embodiment of the present invention is used.
FIG. 4 is a cross-sectional view showing an example of a light-emitting device in which a fluorescent quantum dot-containing composition and a fluorescent quantum dot-dispersed resin shaped product according to the first embodiment of the present invention are used.
FIG. 5 is a cross-sectional view of an example of a fluorescent quantum dot-containing structure according to the second embodiment of the present invention.
FIG. 6 is a cross-sectional view of an example of a light-emitting device to which the fluorescent quantum dot-containing structure according to the second embodiment is applied.
FIG. 7 is a cross-sectional view of another example of a light-emitting device to which the fluorescent quantum dot-containing structure according to the second embodiment is applied.

### DESCRIPTION OF EMBODIMENTS

Hereinafter, the present invention will be described with reference to examples. The following description gives examples of materials, conditions, techniques, and value ranges; however, the present invention is not limited to those mentioned as examples. The materials given as examples may be used alone or may be used in combination with one another, unless otherwise specified.

Unless otherwise specified, the meaning of an expression like "a particular layer is stacked on a particular member (such as a base or layer)" as used herein encompasses not only the case where the particular layer is stacked in direct contact with the member but also the case where the particular layer is stacked above the member, with another layer interposed therebetween. The same applies to expressions like "a particular layer is formed on a particular member (such as a base or layer)" and "a particular layer is placed on a particular member (such as a base or layer)". Unless otherwise specified, the meaning of an expression like "a liquid (such as a coating liquid) is applied onto a particular member (such as a base or layer)" encompasses not only the case where the liquid is applied directly to the member but also the case where the liquid is applied to another layer formed on the member.

Herein, a layer may be termed "layer (Y)" using a reference character "(Y)" to differentiate the layer from other layers. The reference character "(Y)" has no technical meaning, unless otherwise specified. The same applies to other reference characters used in the terms such as "base (X)" and "compound (A)". However, an exception is made for the terms such as "hydrogen atom (H)" in which the reference character obviously represents a specific element.

### [Electronic device]

An electronic device of the present invention, in which a multilayer structure is used, includes an electronic device body and a protective sheet for protecting a surface of the electronic device body. The protective sheet used in the electronic device of the present invention includes a multilayer structure including a base (X) and a layer (Y) stacked on the base (X). The term "multilayer structure" as used in the following description refers to a multilayer structure including the base (X) and the layer (Y), unless otherwise specified. The phrase "multilayer structure of the present invention" refers to a "multilayer structure used in the present invention". The details of the multilayer structure will be described later. The protective sheet may consist only of the multilayer structure or may include another member or another layer. The following should be considered a description of the case where the protective sheet includes the multilayer structure, unless otherwise specified.

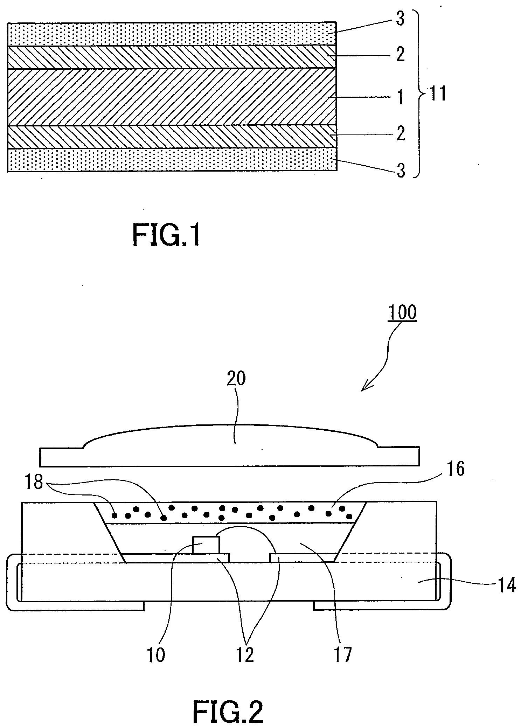

A partial cross-sectional view of an example of the electronic device of the present invention is shown in FIG. 1. An electronic device 11 of FIG. 1 includes an electronic device body 1, a sealing member 2 for sealing the electronic device body 1, and a protective sheet (multilayer structure) 3 for protecting the surface of the electronic device body 1. The sealing member 2 covers the entire surface of the electronic device body 1. The protective sheet 3 is placed on at least one side of the electronic device body 1, with the sealing member 2 interposed therebetween. It suffices for the protective sheet 3 to be placed in such a manner as to protect the surface of the electronic device body 1. The protective sheet 3 may be placed directly on the surface of the electronic device body 1 (this case is not shown) or may, as in FIG. 1, be placed over the surface of the electronic device body 1, with another member such as the sealing member 2 interposed therebetween. As shown in FIG. 1, a first protective sheet may be placed on one side, while a second protective sheet may be placed on the opposite side. In this case, the second protective sheet placed on the opposite side may be the same as or different from the first protective sheet.

A preferred protective sheet protects a fluorescent quantum dot-containing - member from ambient factors such as high temperature, oxygen, and moisture. Examples of the preferred protective sheet include a non-yellowed, transparent optical material that is hydrophobic, that is chemically and mechanically compatible with the fluorescent quantum dot-containing member, that exhibits light stability and chemical stability, and that has resistance to high temperature and heat. It is preferable that at least one protective sheet be refractive index-matched to the fluorescent quantum dot-containing member. In a preferred embodiment, the matrix of the fluorescent quantum dot-containing member and at least one protective sheet contiguous to the fluorescent quantum dot-containing member are refractive index-matched to have similar refractive indices, so that a major portion of light traveling toward the fluorescent quantum dot-containing member through the protective sheet enters the fluorescent material from the protective sheet. This refractive index matching reduces optical loss at the interface between the protective sheet and the matrix.

Examples of the matrix of the fluorescent quantum dot-containing member of the present invention include a polymer, an organic oxide, and an inorganic oxide. In a preferred embodiment, the polymer is substantially semi-transparent or substantially transparent. Examples of a preferred matrix include the following as well as the resin as a dispersion medium described later: epoxy; acrylate; norbornene; polyethylene; poly(vinyl butyral); poly(vinyl acetate); polyurea; polyurethane; silicones and silicone derivatives such as amino silicone (AMS), polyphenylmethylsiloxane, polyphenylalkylsiloxane, polydiphenylsiloxane, polydialkylsiloxane, silsesquioxane, fluorinated silicone, and vinyl- or hydride-substituted silicone; acrylic polymers and copolymers formed from monomers such as methyl methacrylate, butyl methacrylate, and lauryl methacrylate; styrene polymers such as polystyrene, amino polystyrene (APS), and poly(acrylonitrile ethylene styrene) (AES); polymers that are cross-linked with a difunctional monomer such as divinylbenzene; crosslinking agents suitable for crosslinking with ligand materials; and epoxides which combine with ligand amines (such as APS or PEI ligand amines) to form epoxy.

The protective sheet is preferably a solid material and may be a cured liquid, gel, or polymer. The protective sheet may include a flexible or non-flexible material depending on the intended application. The protective sheet is preferably in the form of a flat layer, and may have any shape and surface morphology suitable for the intended lighting application. Preferred materials for use in the protective sheet include any materials for protective sheets which are known to be preferred in the art, as well as the materials for the multilayer structure described later. Examples of preferred barrier materials for use in a protective sheet other than the protective sheet including the multilayer structure described later include glass, a polymer, and an oxide. Examples of the polymer include polyethylene terephthalate (PET). Examples of the oxide include SiO₂, Si₂O₃, TiO₂, and Al₂O₃. These may be used alone or in combination with one another. It is preferable that the or each protective sheet of the fluorescent quantum dot-containing electronic device include at least two layers containing different materials or compositions (e.g., the base (X) and the layer (Y)). In this case, the multilayer protective sheet will be free of, or have a reduced number of, pinhole defects and provide an effective barrier against invasion of oxygen and moisture into the fluorescent quantum dot-containing member. The fluorescent quantum dot-containing electronic device may include any preferred number of protective sheets made of any preferred material or any preferred combination of materials on one side or both sides of the fluorescent quantum dot-containing member. The material, thickness, and number of the protective sheets depend on the specific intended application, and are preferably selected so that the thickness of the fluorescent quantum dot-containing electronic device is minimized while the barrier protection and brightness of the fluorescent quantum dots are maximized. In a preferred embodiment, the or each protective sheet includes a layered product (layered film), preferably a double-layer product (double-layer film), and the or each protective sheet is thick enough to avoid being wrinkled during a production process such as a roll-to-roll process or stacking process. In an embodiment where the fluorescent quantum dot-containing member further contains a heavy metal or another toxic substance, the number or thickness of the protective sheets depend on legal regulations for toxicity, and such regulations may require that a larger number of, or thicker protective sheets be used. Other factors to be considered for the barrier include cost, availability, and mechanical strength.

In a preferred embodiment, the fluorescent quantum dot-containing electronic device includes two or more protective sheets each including the multilayer structure of the present invention, two of the protective sheets being respectively contiguous to both sides of the fluorescent quantum dot-containing member. The electronic device may include, on each side of the fluorescent quantum dot-containing member, at least one protective sheet other than the protective sheet including the multilayer structure of the present invention. That is, the electronic device may include two or three layers (protective sheets) on each side of the fluorescent quantum dot-containing member. In a more preferred embodiment, the fluorescent quantum dot-containing electronic device includes two protective sheets on each side of the fluorescent quantum dot-containing member, at least one of the two protective sheets being the protective sheet including the multilayer structure of the present invention.

The fluorescent quantum dot-containing layer of the present invention can have any desired dimensions, form, structure, and thickness. The fluorescent quantum dots may be embedded in a matrix at any filling ratio appropriate for the desired function. The thickness and width of the fluorescent quantum dot-containing layer can be controlled by any of methods known in the art such as wet coating, spread coating, rotary coating, and screen printing. In a fluorescent quantum dot-containing film according to a particular embodiment, the fluorescent quantum dot-containing member can have a thickness of 500 µm or less, preferably 250 µm or less, more preferably 200 µm or less, even more preferably 50 to 150 µm, most preferably 50 to 100 µm.

In a preferred embodiment, the fluorescent quantum dot-containing electronic device of the present invention includes top and bottom protective sheet layers that are attached in a mechanically hermetic manner. As in the embodiment shown in FIG. 1, the top protective sheet layer and/or the bottom protective sheet layer are compressed together to seal the fluorescent quantum dot-containing member. Preferably, the edges of the protective sheet layers are compressed immediately after placement of the fluorescent quantum dot-containing member and the protective sheet layers so as to minimize exposure of the fluorescent quantum dot-containing member to ambient oxygen and moisture. The edges of the barriers can be hermetically attached, for example, by compression, stamping, melting, rolling, or pressurization.

In a preferred embodiment, an adhesive may be used to attach the top and bottom protective sheet layers of the fluorescent quantum dot-containing electronic device of the present invention in a mechanically hermetic manner. In terms of ease of edge bonding and maintenance of good optical properties of the quantum dots, it is preferable to use a suitable optical adhesive material such as an epoxy.

The fluorescent quantum dot-containing electronic device body of the present invention can be used in any suitable applications, including: backlight units (BLU) for displays of electronic devices such as liquid crystal displays (LCD), televisions, computers, mobile phones, smartphones, personal digital assistants (PDA), video game devices, electronic book readers, and digital cameras; and lighting such as indoor lighting, outdoor lighting, stage lighting, decorative lighting, accent lighting, museum lighting, horticulture lighting, biological lighting, and other types of lighting for uses that require a highly-specific wavelength. The electronic device body can also be used in other lighting applications which would be obvious to persons skilled in the art in view of the invention described herein.

The fluorescent quantum dot-containing electronic device body of the present invention can be used also as a quantum dot-containing down-conversion layer or film suitable for use in photovoltaic applications. The fluorescent quantum dot-containing electronic device body of the present invention is capable of converting a portion of sunlight to lower-energy light absorbable by the active layer of a solar cell. The wavelength of converted light capable of being absorbed and converted to electrical power by the active layer cannot be achieved without the down-conversion by the fluorescent quantum dot-containing electronic device body of the present invention. Thus, a solar cell employing the fluorescent quantum dot-containing electronic device body of the present invention can have an enhanced sunlight conversion efficiency.

The fluorescent quantum dot-containing electronic device body of the present invention can be used also as a light source, a light filter, and/or a down-converter for primary light. In a particular embodiment, the fluorescent quantum dot-containing electronic device body of the present invention is a primary light source, and the fluorescent quantum dot-containing electronic device is an electroluminescent device containing electroluminescent quantum dots that emit photons upon electrical stimulation. In a particular embodiment, the fluorescent quantum dot-containing electronic device is a light filter, and the fluorescent quantum dots absorb light of a particular wavelength or in a particular wavelength range. The fluorescent quantum dot-containing electronic device permits passage of light of a particular wavelength or in a particular wavelength range while absorbing or filtering light of other wavelengths. In a particular embodiment, the fluorescent quantum dot-containing electronic device is a down-converter, in the case of which at least a portion of primary light from a primary light source is absorbed by the fluorescent quantum dots in the fluorescent quantum dot-containing electronic device so that secondary light having a lower energy or a longer wavelength than the primary light is emitted. In a preferred embodiment, the fluorescent quantum dot-containing electronic device functions both as a filter and as a down-converter for primary light, in the case of which a first portion of primary light is permitted to pass through the fluorescent quantum dot-containing electronic device without being absorbed by the fluorescent quantum dots in the fluorescent quantum dot-containing electronic device, while at least a second portion of the primary light is absorbed by the fluorescent quantum dots and down-converted to secondary light having a lower energy or a longer wavelength than the primary light.

The sealing member 2 is an optional member which may be added as appropriate depending on, for example, the type and use of the electronic device body 1. Examples of the sealing member 2 include ethylene-vinyl acetate copolymer and polyvinyl butyral.

The protective sheet of the fluorescent quantum dot-containing electronic device of the present invention may have flexibility. "Flexibility" as defined herein refers to the ability to be wound into a 50-cm-diameter roll. For example, having "flexibility" means that the 50-cm-diameter roll is free of any damage when visually inspected. It is preferable for the electronic device or the protective sheet to be capable of being wound into a roll with a diameter of less than 50 cm, since this means that the electronic device or the protective sheet has higher flexibility.

The protective sheet including the multilayer structure is superior in gas barrier properties and water vapor barrier properties. The use of the protective sheet thus makes it possible to obtain an electronic device that suffers little degradation even under harsh conditions. In addition, the protective sheet has high transparency, and its use makes it possible to obtain a highly light transmissive electronic device.

The multilayer structure can be used as a film called a substrate film, such as a substrate film for LCDs, a substrate film for organic ELs, and a substrate film for electronic paper. In this case, the multilayer structure may function both as a substrate and as a protective film. The electronic device to be protected by the protective sheet is not limited to those mentioned as examples above, and may be, for example, an IC tag, a device for optical communication, or a fuel cell.

The protective sheet may include a surface protection layer placed on one or both of the surfaces of the multilayer structure. It is preferable for the surface protection layer to be a layer made of a scratch-resistant resin. A surface protection layer for a device such as a solar cell which may be used outdoors is preferably made of a resin having high weather resistance (e.g., light resistance). For protecting a surface required to permit transmission of light, a surface protection layer having high light transmittance is preferred. Examples of the material of the surface protection layer (surface protection film) include acrylic resin, polycarbonate, polyethylene terephthalate, polyethylene naphthalate, ethylene-tetrafluoroethylene copolymer, polytetrafluoroethylene, 4-fluoroethylene-perchloroalkoxy copolymer, 4-fluoroethylene-6-fluoropropylene copolymer, 2-ethylene-4-fluoroethylene copolymer, polychlorotrifluoroethylene, polyvinylidene fluoride, and polyvinyl fluoride. In an example, the protective sheet includes an acrylic resin layer placed on one of its surfaces.

An additive (e.g., an ultraviolet absorber) may be added to the surface protection layer to increase the durability of the surface protection layer. A preferred example of the surface protection layer having high weather resistance is an acrylic resin layer to which an ultraviolet absorber has been added. Examples of the ultraviolet absorber include, but are not limited to, ultraviolet absorbers based on benzotriazole, benzophenone, salicylate, cyanoacrylate, nickel, or triazine. In addition, another additive such as a stabilizer, light stabilizer, or antioxidant may be used in combination.

When the protective sheet is joined to the sealing member sealing the fluorescent quantum dot-containing electronic device body, it is preferable for the protective sheet to include a resin layer for joining which is highly adhesive to the sealing member. Examples of the resin layer for joining which may be used when the sealing member is formed of ethylene-vinyl acetate copolymer include a polyethylene terephthalate layer with improved adhesion to ethylene-vinyl acetate copolymer. The layers constituting the protective sheet may be bonded together using a commonly-known adhesive or an adhesive layer as described above.

### [First embodiment]

A fluorescent quantum dot-containing electronic device according to the first embodiment of the present invention employs a fluorescent quantum dot-dispersed resin shaped product. The fluorescent quantum dot-dispersed resin shaped product can be obtained by dispersing fluorescent quantum dots in a resin to prepare a dispersion (composition) and forming a shaped product from the dispersion. The method for shaping is not particularly limited, and a commonly-known method can be used. The resin as a dispersion medium is preferably a cycloolefin (co)polymer. Examples of the cycloolefin (co)polymer include a cycloolefin polymer (COP) represented by the formula [Q-1] given below and a cycloolefin copolymer (COC) represented by the formula [Q-2] given below. As such a cycloolefin (co)polymer there can be used as a commercially-available product. Examples of commercially-available products of the COP type include ZEONEX (registered trademark) series (manufactured by Zeon Corporation), and examples of commercially-available products of the COC type include APL 5014DP (manufactured by Mitsui Chemicals, Inc. and having a chemical structure represented by -(C₂H₄)ₓ(C₁₂H₁₆)_{y}-, where x and y are real numbers of more than 0 and less than 1 which represent the copolymerization ratio).

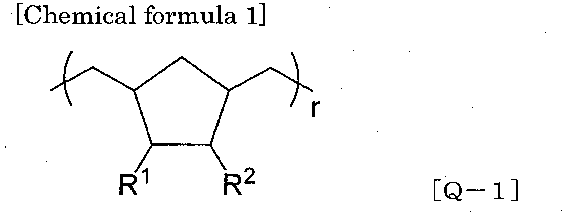

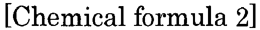

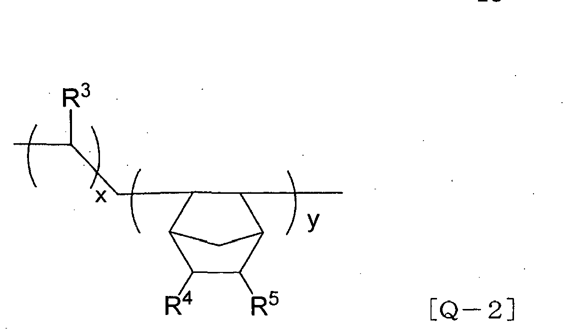

In the formula [Q-1], R¹ and R² are the same as or different from each other and each independently represent a monovalent group selected from the group consisting of: a hydrogen atom; a linear or branched saturated hydrocarbon group having 1 to 6 carbon atoms; a halogen atom selected from a chlorine atom and a fluorine atom; and a trihalomethyl group in which the halogen atom is a chlorine atom or a fluorine atom. When R¹ and R² are each a hydrocarbon group, the hydrocarbon groups may bind to each other at their neighboring substitution sites to form at least one 5 to 7-membered ring structure of a saturated hydrocarbon. r is a positive integer.

In the formula [Q-2], R³ represents a monovalent group selected from the group consisting of: a hydrogen atom; a linear or branched saturated hydrocarbon group (alkyl group) having 1 to 6 carbon atoms; a halogen atom selected from a chlorine atom and a fluorine atom; and a trihalomethyl group in which the halogen atom is a chlorine atom or a fluorine atom. R⁴ and R⁵ are the same as or different from each other and each independently represent a monovalent group selected from the group consisting of a hydrogen atom; a linear or branched saturated hydrocarbon group having 1 to 6 carbon atoms; a halogen atom selected from a chlorine atom and a fluorine atom; and a trihalomethyl group in which the halogen atom is a chlorine atom or a fluorine atom. When R⁴ and R⁵ are each a hydrocarbon group, the hydrocarbon groups may bind to each other at their neighboring substitution sites to form at least one 5 to 7-membered ring structure of a saturated hydrocarbon. x and y are real numbers of more than 0 and less than 1 and satisfy a relationship of x + y = 1.

The cycloolefin polymer (COP) represented by the formula [Q-1] can be obtained, for example, by ring-opening metathesis polymerization of a norbornene as a raw material with the aid of a Grubbs catalyst or the like followed by hydrogenation. The cycloolefin copolymer (COC) represented by the formula [Q-2] can be obtained, for example, by copolymerization of a norbornene as a raw material with ethylene or the like with the aid of a metallocene catalyst.

The method for dispersing the fluorescent quantum dots in the resin is preferably, but not limited to, a method in which a solution is prepared by dissolving the resin in a solvent under inert gas atmosphere, a dispersion prepared by dispersing the fluorescent quantum dots in a dispersion medium is added to the solution under inert gas atmosphere, and the mixture is kneaded. The dispersion medium used in this case is preferably a solvent capable of dissolving the resin, and the dispersion medium is more preferably identical to the solvent in the solution of the resin. Various solvents and dispersion mediums can be used without limitation. A hydrocarbon solvent such as toluene, xylene (o-, m-, or p-xylene), ethylbenzene, or tetralin can be preferably used. A chlorine-containing hydrocarbon solvent such as chlorobenzene, dichlorobenzene (o-, m-, or p-dichlorobenzene), or trichlorobenzene can also be used. Examples of the inert gas used in the above steps include helium gas, argon gas, and nitrogen gas. These gases may be used alone or may be used in combination by being mixed at an arbitrary ratio.

The fluorescent quantum dots used in the first embodiment are those having a diameter of 1 to 100 nm and, when having a diameter of several tens of nanometers or less, exhibit a quantum effect. The diameter of the fluorescent quantum dots is preferably in the range of 2 to 20 nm.

The fluorescent quantum dot has a structure composed of a core which is an inorganic fluorescent material and a capping layer (an organic passivation layer having an aliphatic hydrocarbon group, for example) coordinated with the surface of the inorganic fluorescent material. The core (metallic portion) which is an inorganic fluorescent material is covered with the organic passivation layer. In general, fluorescent quantum dots have a core, with the surface of which an organic passivation layer is coordinated for the main purpose of, for example, preventing aggregation. As well as serving to prevent aggregation, this organic passivation layer (also called "shell") performs the functions of: protecting the core particle from ambient chemical conditions; imparting electrical stability to the surface; and controlling the solubility in particular solvent systems. The chemical structure of the organic passivation layer can be selected depending on the intended purpose. For example, there may be selected an organic molecule including a linear or branched aliphatic hydrocarbon group (e.g., an alkyl group) having about 6 to 18 carbon atoms.

### [Inorganic fluorescent material]

Examples of the inorganic fluorescent material include nanocrystals of II-VI compound semiconductors and nanocrystals of III-V compound semiconductors. The configuration of these nanocrystals is not particularly limited, and examples of the nanocrystals include: a crystal having a core-shell structure in which an InP nanocrystal as a core is covered with a shell made of ZnS/ZnO or the like; a crystal having a structure having no clear boundary between a core and a shell and having a gradiently-varying composition; a mixture crystal in which two or more compound crystals are separately present in one and the same crystal; and an alloy of two or more nanocrystalline compounds.

### [Capping agent]

Examples of the capping agent (reagent for forming the organic passivation layer) that coordinates with the surface of the inorganic fluorescent material include an organic molecule having a linear or branched aliphatic hydrocarbon group having 2 to 30 carbon atoms, preferably 4 to 20 carbon atoms, more preferably 6 to 18 carbon atoms. The capping agent (reagent for forming the organic passivation layer) that coordinates with the surface of the inorganic fluorescent material has a functional group for coordination with the inorganic fluorescent material. Examples of the functional group include carboxyl, amino, amide, nitrile, hydroxy, ether, carbonyl, sulfonyl, phosphonyl, and mercapto groups. Among these, the carboxyl group is preferred.

The composition used for fabrication of the fluorescent quantum dot-dispersed resin shaped product of the fluorescent quantum dot-containing electronic device according to the first embodiment contains a resin (e.g., cycloolefin (co)polymer) and fluorescent quantum dots dispersed uniformly in the resin at a concentration of 0.01 to 20 mass%. It is advantageous that the fluorescent quantum dot-containing composition according to the first embodiment contain a cycloolefin (co)polymer and fluorescent quantum dots uniformly dispersed in the cycloolefin (co)polymer, preferably at a concentration of more than 0.1 mass% and less than 15 mass%, more preferably at a concentration of more than 1 mass% and less than 10 mass%. It is not preferable that the concentration of the fluorescent quantum dots be less than 0.01 mass%, because in this case the fluorescent quantum dot-dispersed resin shaped product cannot provide an emission intensity sufficient for use in a light-emitting element. It is not preferable that the concentration of the fluorescent quantum dots be more than 20 mass%, because in this case the fluorescent quantum dots may undergo aggregation leading to failure to obtain a fluorescent quantum dot-dispersed resin shaped product in which the fluorescent quantum dots are uniformly dispersed.

### [Method for preparing fluorescent quantum dots]

The fluorescent quantum dots used in the first embodiment are prepared as follows. A metal precursor that allows formation of desired compound semiconductor nanoparticles is used to produce nanocrystals, which are then dispersed in an organic solvent. The nanocrystals are subsequently treated with a predetermined reactive compound (compound for forming the shell), and thus fluorescent quantum dots each having a structure in which a hydrocarbon group coordinates with the surface of an inorganic fluorescent material can be prepared. The method for the treatment is not particularly limited, and an example is a method in which the dispersion of the nanocrystals is refluxed in the presence of the reactive compound. Another available example of the method for fabricating fluorescent quantum dots is a method disclosed in JP 2006-199963 A.

For the fluorescent quantum dots used in the present embodiment, the amount of the hydrocarbon groups in the organic passivation layer covering the surface of the inorganic fluorescent material (core) is not particularly limited. It is advantageous for the amount of the hydrocarbon groups to be such that the content of the hydrocarbon chains of the hydrocarbon groups is typically 2 to 500 moles, preferably 10 to 400 moles, and more preferably 20 to 300 moles, per particle of the inorganic fluorescent material (core). If the content of the hydrocarbon chains is less than 2 moles, the function as an organic passivation layer cannot be provided, with the result that, for example, the particles of the fluorescent material are likely to undergo aggregation. If the content of the hydrocarbon chains is more than 500 moles, the intensity of emission from the core is reduced, in addition to which excess hydrocarbon groups having failed to coordinate with the inorganic fluorescent material remain, thus making performance degradation of the liquid sealing resin more likely. There also occurs an increase in cost of the fluorescent quantum dots.

The fluorescent quantum dot-dispersed resin shaped product according to the first embodiment may be produced by forming a composition containing fluorescent quantum dots into a given shape. This shaped product performs the beneficial function of absorbing at least a portion of light applied from a light source and allowing the fluorescent quantum dots contained in the shaped product to emit secondary light. An example of the method for shaping the fluorescent quantum dot-containing composition is a method in which the composition is applied to a base or charged in a mold, then dried by heating under atmosphere of the above-mentioned inert gas to remove the solvent, and optionally separated from the base or the mold. The fluorescent quantum dot-containing composition can be used also as a sealing member for sealing an LED chip.

An example of the method for producing the fluorescent quantum dot-dispersed resin shaped product is a method including the steps of: preparing a solution of a cycloolefin (co)polymer dissolved in a solvent; dispersing fluorescent quantum dots in the solution so that the concentration of the fluorescent quantum dots in the resulting shaped product will fall within the range of 0.01 to 20 mass%, and then kneading the dispersion to produce a fluorescent quantum dot-containing composition; and applying the fluorescent quantum dot-containing composition to a base or charging the fluorescent quantum dot-containing composition in a mold and then drying the composition by heating. The solvent and the dispersion medium are as previously described.

The production of the fluorescent quantum dot-dispersed resin shaped product by the above steps such as drying by heating can optionally be followed by pressure forming to produce a resin lens, a resin sheet, or a resin film, for example.

FIG. 2 shows a cross-sectional view of an example of a light-emitting device in which a fluorescent quantum dot-containing composition according to the first embodiment is used in at least a part of a sealing member. In FIG. 2, a light-emitting device 100 includes an LED chip 10, at least one leading electrode 12, a cup 14, and sealing members 16 and 17. A resin lens 20 may be placed on the top of the light-emitting device 100 where necessary. The cup 14 can be formed from an appropriate resin or ceramic. The LED chip 10 is not limited to a particular one, and a light-emitting diode cooperating with fluorescent quantum dots to form a light source of appropriate wavelength can be used. The sealing member 16 can be formed using a fluorescent quantum dot-containing composition in which fluorescent quantum dots 18 are dispersed. These components can be combined to form, for example, a white light source that emits white light through the sealing member 16 by making use of light emission from the LED chip 10. The sealing member 17 seals, for example, the LED and leading wire, and is composed of a resin such as an epoxy or silicone resin which is commonly used as a resin for sealing an LED. The production of these sealing members 16 and 17 can be accomplished as follows: A predetermined amount of resin (such as an epoxy or silicone resin) is first injected into the cup 14 under atmosphere of inert gas (such as argon gas) and hardened by a commonly-known technique to form the sealing member 17, then the fluorescent quantum dot-containing composition is injected onto the sealing member 17 and dried by heating to form the sealing member 16.

A lens-shaped resin (resin lens 20), at least partially convex film, or uniformly-thick film formed of the fluorescent quantum dot-dispersed resin shaped product may be placed above the sealing member 16 held in the cup 14 so that light may be emitted through the resin lens 20. In this case, it is not necessary to disperse the fluorescent quantum dots 18 in the sealing member 16. When the fluorescent quantum dot-containing composition is used in at least a part of the sealing member 16 for sealing the LED chip, it is preferable for the sealing member to have a thickness of 0.01 or more and less than 0.4 mm. It is not preferable that the thickness of the sealing member 16 be more than 0.4 mm, because in this case, depending on the depth of the recess of the cup 14, the wire connected to the leading electrode 12 may be subjected to an excessive load when the sealing member 16 is secured within the recess of the cup 14. If the thickness of the sealing member 16 for sealing the LED chip is less than 0.01 mm when the fluorescent quantum dot-containing composition is used in at least a part of the sealing member, the sealing member fails to function sufficiently as a fluorescent material-containing sealing member.

When the fluorescent quantum dots 18 are not dispersed in the sealing member 16, it is preferable to place the lens-shaped resin 20 (resin lens 20) formed of the fluorescent quantum dot-dispersed resin shaped product.

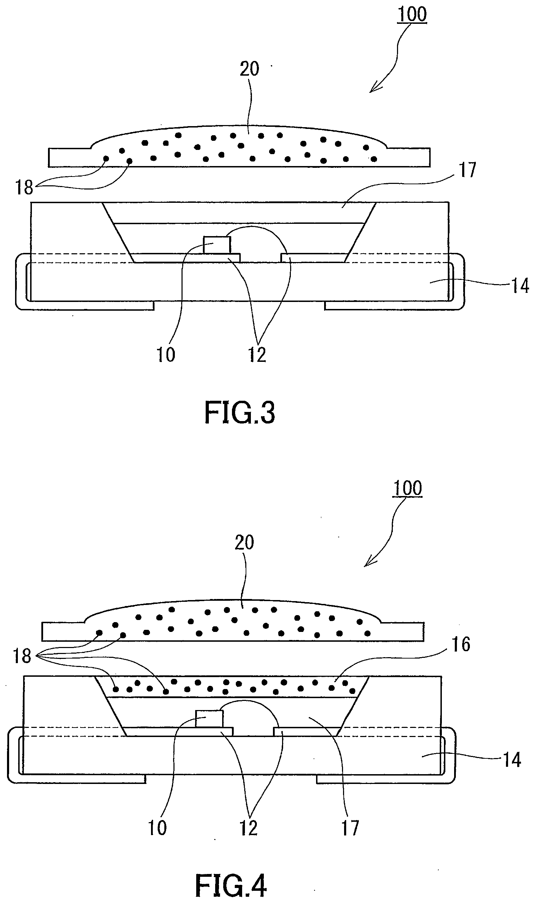

FIG. 3 shows a cross-sectional view of an example of a light-emitting device in which a fluorescent quantum dot-dispersed resin shaped product according to the first embodiment is used. The same components as shown in FIG. 2 are denoted by the same reference characters. The light-emitting device of FIG. 3 is an example where the fluorescent quantum dot-containing composition according to the first embodiment is not used in the sealing member. In this case, the lens-shaped resin (resin lens 20) is formed of a fluorescent quantum dot-dispersed resin shaped product obtained by shaping a composition prepared by dispersing the fluorescent quantum dots 18 in a cycloolefin (co)polymer at a concentration of 0.01 to 20 mass%.

FIG. 4 shows a cross-sectional view of an example of a light-emitting device in which a fluorescent quantum dot-containing composition and a fluorescent quantum dot-dispersed resin shaped product according to the first embodiment are used. The same components as shown in FIG. 1 are denoted by the same reference characters. The light-emitting device of FIG. 4 is an example where the fluorescent quantum dot-containing composition according to the first embodiment is used in a part of a sealing member, above which the resin lens 20 formed of the fluorescent quantum dot-dispersed resin shaped product is placed. Also in this example, both of the resin materials are formed by dispersing the fluorescent quantum dots 18 in a cycloolefin (co)polymer at a concentration of 0.01 to 20 mass%.

The light-emitting devices shown in FIG. 2, FIG. 3, and FIG. 4 can reduce quenching of the fluorescent quantum dots and maintain stable operation as a light-emitting device. Hence, an electronic device such as a mobile phone, television, display, or panel having any of these light-emitting devices incorporated therein, and a machine device such as an automobile, computer, or video game device having the electronic device incorporated therein, can be stably operated over a long time.

### [Second embodiment]

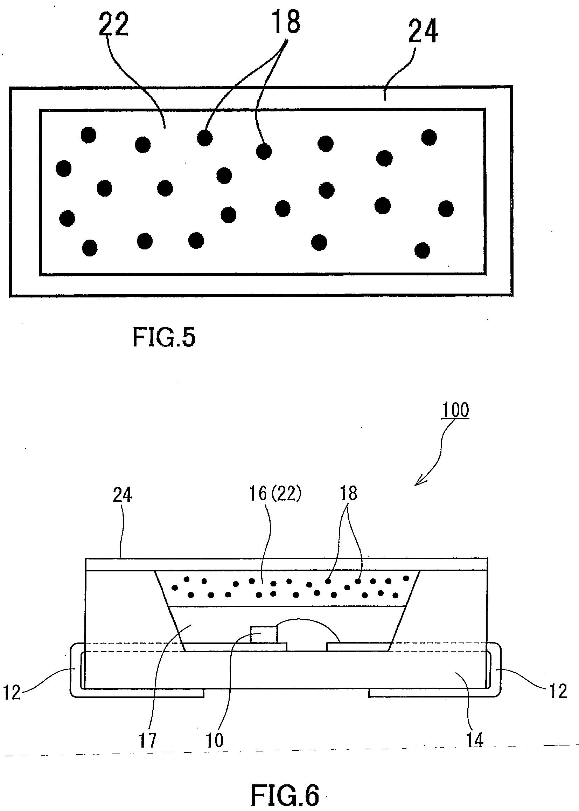

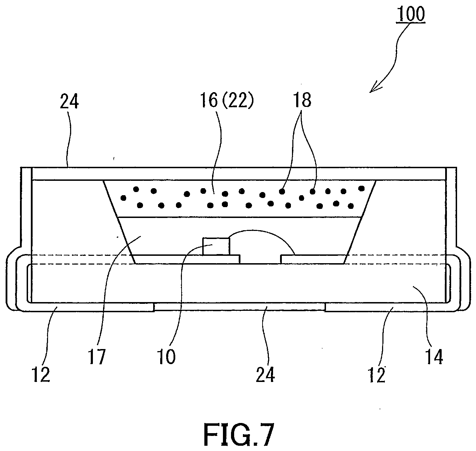

FIG. 5 shows a cross-sectional view of an example of a fluorescent quantum dot-containing structure according to the second embodiment. In FIG. 5, the fluorescent quantum dot-containing structure includes: a fluorescent quantum dot-dispersed resin shaped product 22 containing a resin as a dispersion medium and fluorescent quantum dots 18 dispersed in the resin at a concentration of 0.01 to 20 mass%; and a gas barrier layer (protective sheet) 24 covering the entire surface of the fluorescent quantum dot-dispersed resin shaped product 22 to reduce transmission of gas such as oxygen into the fluorescent quantum dot-dispersed resin shaped product 22. In another embodiment, the gas barrier layer 24 may be designed to cover a part of the surface of the fluorescent quantum dot-dispersed resin shaped product 22 (see FIGS. 6 and 7). It is preferable for the gas barrier layer 24 to be capable of reducing transmission of not only oxygen but also water vapor.

The gas barrier layer 24 as defined herein refers to a layer capable of protecting the fluorescent quantum dots 18 from gas such as oxygen to such a degree that the spectral radiant energy of the fluorescent quantum dots 18 can be maintained at 80.0% or more of the initial value after a light-emitting diode (LED) is caused to emit light in the vicinity of the fluorescent quantum dot-containing structure for 2,000 consecutive hours. For the electronic device of the present invention, it is preferable that the spectral radiant energy of the fluorescent quantum dots 18 be 85.0% or more, more preferably 89.0% or more, even more preferably 90.0% or more, of the initial value after light emission for 2,000 consecutive hours. The spectral radiant energy is a radiant energy at the fluorescence wavelength of the fluorescent quantum dots.

As the resin as a dispersion medium which is a constituent of the fluorescent quantum dot-dispersed resin shaped product 22 there can be used, for example, the cycloolefin (co)polymer described in the first embodiment. In addition, the method for producing the fluorescent quantum dot-dispersed resin shaped product which is described in the first embodiment can be employed as the method for producing the fluorescent quantum dot-dispersed resin shaped product 22.

The gas barrier layer 24 can be composed of the multilayer structure of the present invention. All of these materials constituting the multilayer structure have good gas barrier properties, and using them to compose the gas barrier layer 24 makes it possible to protect the fluorescent quantum dots 18, for example, from oxygen and water.

Both the above fluorescent quantum dot-dispersed resin shaped product 22 and the multilayer structure of the present invention constituting the gas barrier layer 24 are light transmissive. Thus, light produced by a light-emitting diode can be transmitted to the fluorescent quantum dots 18, and wavelength-converted light resulting from conversion by the fluorescent quantum dots 18 can be transmitted to the outside of the fluorescent quantum dot-dispersed resin shaped product 22.

FIG. 6 shows a cross-sectional view of an example of a light-emitting device to which the fluorescent quantum dot-containing structure according to the second embodiment is applied. In FIG. 6, the light-emitting device 100 includes an LED chip 10, at least one leading electrode 12, a cup 14, a sealing member 16 having fluorescent quantum dots 18 dispersed therein, a sealing member 17 having no fluorescent quantum dots 18 dispersed therein, and a gas barrier layer 24. In the example of FIG. 6, the gas barrier layer 24 is used as a lid for the cup 14. The sealing member 16 is composed of the fluorescent quantum dot-dispersed resin shaped product 22 formed from the fluorescent quantum dot-containing composition described in the first embodiment. The sealing member 16 and the sealing member 17 can be produced in the same manner as in the case of FIG. 1. Among these components, the fluorescent quantum dots 18, the fluorescent quantum dot-dispersed resin shaped product 22, and the gas barrier layer 24 are as previously described. The LED chip 10 is not limited to a particular one, and a light-emitting diode cooperating with the fluorescent quantum dots to form a light source of appropriate wavelength can be used. The cup 14 can be formed from an appropriate resin or ceramic. The sealing member 17 is formed, for example, from an epoxy or silicone resin and seals the LED chip 10, the leading electrode 12, etc.

FIG. 7 shows a cross-sectional view of another example of a light-emitting device to which the fluorescent quantum dot-containing structure according to the second embodiment is applied. The same components as shown in FIG. 6 are denoted by the same reference characters. In the example of FIG. 7, the gas barrier layer 24 covers the the surface of the cup 14 (including the portion corresponding to a lid in FIG. 6) and the surface of the leading electrode 12 exposed outside the cup 14. A part of the surface of the leading electrode 12 is exposed without being covered by the gas barrier layer 24. This is in order to, for example, obtain electrical conduction between the light-emitting device and the power-supply path on a mounting board. Also in this example, the gas barrier layer 24 covers the face of the sealing member 16 that corresponds to an upper face as seen in the figure. This can eliminate or reduce the penetration of gas such as oxygen to the fluorescent quantum dots 18 dispersed in the sealing member 16. A portion of light from the LED chip 10 is converted to light of a different wavelength by the fluorescent quantum dots 18 dispersed in the sealing member 16, and then the converted light is mixed with light from the LED chip 10 and transmitted through the gas barrier layer 24 to the outside.

In the configuration shown in FIG. 6, the lid of the cup 14 is formed by the gas barrier layer 24 and covers the face of the sealing member 16 that corresponds to an upper face as seen in the figure. This can eliminate or reduce the penetration of gas such as oxygen to the fluorescent quantum dots 18 dispersed in the sealing member 16.

The fluorescent quantum dot-dispersed resin composition, the shaped product thereof, or the fluorescent quantum dot-containing structure, which has been described above, can be applied, for example, to plant growth lighting, colored lighting, white lighting, an LED backlight light source, a fluorescent material-containing liquid crystal filter, a fluorescent material-containing resin sheet, a light source for a hair restoration device, or a light source for a communication device.

### [Multilayer structure]

The multilayer structure used in the electronic device (which is preferably a fluorescent quantum dot-containing electronic device) of the present invention includes a base (X) and a layer (Y) stacked on the base (X). The layer (Y) includes a metal oxide (A), a phosphorus compound (B), and cations (Z) with an ionic charge (F_{Z}) of 1 or more and 3 or less. The phosphorus compound (B) contains a moiety capable of reacting with the metal oxide (A). In the layer (Y), the number of moles (N_{M}) of metal atoms (M) constituting the metal oxide (A) and the number of moles (N_{P}) of phosphorus atoms derived from the phosphorus compound (B) satisfy a relationship of 0.8 ≤ N_{M}/N_{P} ≤ 4.5. In the layer (Y), the number of moles (N_{M}) of the metal atoms (M) constituting the metal oxide (A), the number of moles (N_{Z}) of the cations (Z), and the ionic charge (F_{Z}) of the cations (Z) satisfy a relationship of 0.001 ≤ F_{Z} × N_{Z}/N_{M} ≤ 0.60. The metal atoms (M) refer to all metal atoms included in the metal oxide (A).

The metal oxide (A) and the phosphorus compound (B) included in the layer (Y) may have undergone a reaction. The cations (Z) may have formed a salt with the phosphorus compound (B) in the layer (Y). When the metal oxide (A) has undergone a reaction in the layer (Y), a moiety derived from the metal oxide (A) in the reaction product is regarded as the metal oxide (A). When the phosphorus compound (B) has undergone a reaction in the layer (Y), the number of moles of phosphorus atoms in the reaction product which are derived from the phosphorus compound (B) is included in the number of moles (N_{P}) of phosphorus atoms derived from the phosphorus compound (B). When the cations (Z) have formed a salt in the layer (Y), the number of moles of the cations (Z) constituting the salt is included in the number of moles (N_{Z}) of the cations (Z).

The multilayer structure of the present invention exhibits good barrier properties by virtue of the relationship of 0.8 ≤ N_{M}/N_{P} ≤ 4.5 being satisfied in the layer (Y). Additionally, by virtue of the relationship of 0.001 ≤ F_{Z} × N_{Z}/N_{M} ≤ 0.60 being satisfied in the layer (Y), the multilayer structure used in the electronic device of the present invention exhibits good barrier properties even after being exposed to physical stresses such as that caused by a stretching process.

The ratio (molar ratio) among N_{M}, N_{P}, and N_{Z} in the layer (Y) can be considered equal to that employed in preparation of the first coating liquid (U).

### [Base (X)]

The material of the base (X) is not particularly limited, and a base made of any of various materials can be used. Examples of the material of the base (X) include: resins such as thermoplastic resins and thermosetting resins; wood; glass; metals; and metal oxides. Among these, thermoplastic resins and fiber assemblies are preferred, and thermoplastic resins are more preferred. The form of the base (X) is not particularly limited, and the base (X) may be in the form of a layer such as in the form of a film or sheet. It is preferable for the base (X) to include at least one selected from the group consisting of a thermoplastic resin film layer and an inorganic deposited layer. In this case, the base may consist of a single layer or may include two or more layers. It is more preferable for the base (X) to include a thermoplastic resin film layer, and the base (X) may further include an inorganic deposited layer (X') in addition to the thermoplastic resin film layer.

Examples of the thermoplastic resin used in the base (X) include: polyolefin resins such as polyethylene and polypropylene; polyester resins such as polyethylene terephthalate (PET), polyethylene-2,6-naphthalate, polybutylene terephthalate, and copolymers thereof; polyamide resins such as nylon-6, nylon-66, and nylon-12; hydroxy group-containing polymers such as polyvinyl alcohol and ethylene-vinyl alcohol copolymer; polystyrene; poly(meth)acrylic acid ester; polyacrylonitrile; polyvinyl acetate; polycarbonate; polyarylate; regenerated cellulose; polyimide; polyetherimide; polysulfone; polyethersulfone; polyetheretherketone; and ionomer resins. At least one thermoplastic resin selected from the group consisting of polyethylene, polypropylene, polyethylene terephthalate, nylon-6, and nylon-66 is preferred as the material of the base (X).

When a film made of such a thermoplastic resin is used as the base (X), the base (X) may be an oriented film or a non-oriented film. In terms of high suitability for processes (such as suitability for printing or lamination) of the resulting multilayer structure, an oriented film, particularly a biaxially-oriented film, is preferred. The biaxially-oriented film may be a biaxially-oriented film produced by any one method selected from simultaneous biaxial stretching, sequential biaxial stretching, and tubular stretching.

### [Inorganic deposited layer (X')]

The inorganic deposited layer (X') is preferably one that has barrier properties against oxygen and water vapor and more preferably one that further has transparency. The inorganic deposited layer (X') can be obtained by vapor deposition of an inorganic substance. Examples of the inorganic substance include metals (such as aluminum), metal oxides (such as silicon oxide and aluminum oxide), metal nitrides (such as silicon nitride), metal oxynitrides (such as silicon oxynitride), and metal carbonitrides (such as silicon carbonitride). Among these, aluminum oxide, silicon oxide, magnesium oxide, and silicon nitride are preferred in that an inorganic deposited layer formed of any of these substances has good barrier properties against oxygen and water vapor.

The method for forming the inorganic deposited layer (X') is not particularly limited, and available methods include: physical vapor deposition processes such as vacuum vapor deposition (e.g., resistive heating vapor deposition, electron beam vapor deposition, and molecular beam epitaxy), sputtering, and ion plating; and chemical vapor deposition processes such as thermal chemical vapor deposition (e.g., catalytic chemical vapor deposition), photochemical vapor deposition, plasma chemical vapor deposition (e.g., capacitively coupled plasma process, inductively coupled plasma process, surface wave plasma process, electron cyclotron resonance plasma process, and dual magnetron process), atomic layer deposition, and organometallic vapor deposition.

The thickness of the inorganic deposited layer (X') is preferably in the range of 0.002 to 0.5 µm, more preferably in the range of 0.005 to 0.2 µm, and even more preferably in the range of 0.01 to 0.1 µm, although the preferred thickness may vary depending on the type of the component constituting the inorganic deposited layer (X'). A thickness at which good barrier properties and mechanical properties of the multilayer structure are achieved can be selected within the above range. If the thickness of the inorganic deposited layer (X') is less than 0.002 µm, the repeatability of exhibition of the barrier properties of the inorganic deposited layer against oxygen and water vapor is likely to diminish, and the inorganic deposited layer may fail to exhibit sufficient barrier properties. If the thickness of the inorganic deposited layer (X') is more than 0.5 µm, the barrier properties of the inorganic deposited layer (X') are likely to deteriorate when the multilayer structure is pulled or bent.

When the base (X) is in the form of a layer, the thickness of the base (X) is preferably in the range of 1 to 1,000 µm, more preferably in the range of 5 to 500 µm, and even more preferably in the range of 9 to 200 µm, in terms of high mechanical strength and good processability of the resulting multilayer structure.

### [Metal oxide (A)]

It is preferable for the metal atoms (M) constituting the metal oxide (A) to have two or more valences. The metal atoms (M) may consist of one type of atoms or may include two or more types of atoms. Atoms from the group consisting of aluminum, titanium, and zirconium are selected as the metal atoms (M), and more preferred are aluminum atoms, in terms of efficiency of production of the metal oxide (A) and better gas barrier properties and water vapor barrier properties of the resulting multilayer structure. That is, it is preferable for the metal atoms (M) to include aluminum atoms.

The total proportion of aluminum, titanium, and zirconium atoms in the metal atoms (M) is typically 60 mol% or more and may be 100 mol%. The proportion of aluminum atoms in the metal atoms (M) is typically 50 mol% or more and may be 100 mol%. The metal oxide (A) can be produced by methods such as liquid-phase synthesis, gas-phase synthesis, and solid grinding.

The metal oxide (A) may be a hydrolytic condensate of a compound (L) having the metal atom (M) to which a hydrolyzable characteristic group is bonded. Examples of the characteristic group include those represented by R¹ in the general formula [I] given below. The hydrolytic condensate of the compound (L) can be substantially regarded as the metal oxide (A). Hence, the term "metal oxide (A)" as used herein is interchangeable with the term "hydrolytic condensate of the compound (L)", while the term "hydrolytic condensate of the compound (L)" as used herein is interchangeable with the term "metal oxide (A)".

### [Compound (L) containing metal atom (M) to which hydrolyzable characteristic group is bonded]

In terms of ease of control of the reaction with the phosphorus compound (B) and in terms of good gas barrier properties of the resulting multilayer structure, it is preferable for the compound (L) to include at least one compound (L¹) represented by the following general formula [I].

M¹(R¹)ₘ(R²)ₙ₋ₘ. [I]

In the formula, M¹ is selected from the group consisting of aluminum, titanium, and zirconium. R¹ is a halogen atom (fluorine atom, chlorine atom, bromine atom, or iodine atom), NO₃, an optionally substituted alkoxy group having 1 to 9 carbon atoms, an optionally substituted acyloxy group having 1 to 9 carbon atoms, an optionally substituted alkenyloxy group having 3 to 9 carbon atoms, an optionally substituted β-diketonato group having 5 to 15 carbon atoms, or a diacylmethyl group having an optionally substituted acyl group having 1 to 9 carbon atoms. R² is an optionally substituted alkyl group having 1 to 9 carbon atoms, an optionally substituted aralkyl group having 7 to 10 carbon atoms, an optionally substituted alkenyl group having 2 to 9 carbon atoms, or an optionally substituted aryl group having 6 to 10 carbon atoms. m is an integer of 1 to n. n is equal to the valence of M¹. When there are two or more atoms or groups represented by R¹, the atoms or groups represented by R¹ may be the same as or different from each other. When there are two or more groups represented by R², the atoms or groups represented by R² may be the same as or different from each other.

Examples of the alkoxy group represented by R¹ include methoxy, ethoxy, n-propoxy, isopropoxy, n-butoxy, isobutoxy, sec-butoxy, tert-butoxy, benzyloxy, diphenylmethoxy, trityloxy, 4-methoxybenzyloxy, methoxymethoxy, 1-ethoxyethoxy, benzyloxymethoxy, 2-trimethylsilylethoxy, 2-trimethylsilylethoxymethoxy, phenoxy, and 4-methoxyphenoxy groups.

Examples of the acyloxy group represented by R¹ include acetoxy, ethylcarbonyloxy, n-propylcarbonyloxy, isopropylcarbonyloxy, n-butylcarbonyloxy, isobutylcarbonyloxy, sec-butylcarbonyloxy, tert-butylcarbonyloxy, and n-octylcarbonyloxy groups.

Examples of the alkenyloxy group represented by R¹ include allyloxy, 2-propenyloxy, 2-butenyloxy, 1-methyl-2-propenyloxy, 3-butenyloxy, 2-methyl-2-propenyloxy, 2-pentenyloxy, 3-pentenyloxy, 4-pentenyloxy, 1-methyl-3-butenyloxy, 1,2-dimethyl-2-propenyloxy, 1,1-dimethyl-2-propenyloxy, 2-methyl-2-butenyloxy, 3-methyl-2-butenyloxy, 2-methyl-3-butenyloxy, 3-methyl-3-butenyloxy, 1-vinyl-2-propenyloxy, and 5-hexenyloxy groups.

Examples of the β-diketonato group represented by R¹ include 2,4-pentanedionato, 1,1,1-trifluoro-2,4-pentanedionato, 1,1,1,5,5,5-hexafluoro-2,4-pentanedionato, 2,2,6,6-tetramethyl-3,5-heptanedionato, 1,3-butanedionato, 2-methyl-1,3-butanedionato, 2-methyl-1,3-butanedionato, and benzoylacetonato groups.

Examples of the acyl group of the diacylmethyl group represented by R¹ include: aliphatic acyl groups having 1 to 6 carbon atoms such as formyl, acetyl, propionyl (propanoyl), butyryl (butanoyl), valeryl (pentanoyl), and hexanoyl groups; and aromatic acyl (aroyl) groups such as benzoyl and toluoyl groups.

Examples of the alkyl group represented by R² include methyl, ethyl, n-propyl, isopropyl, n-butyl, isobutyl, sec-butyl, tert-butyl, n-pentyl, isopentyl, n-hexyl, isohexyl, 3-methylpentyl, 2-methylpentyl, 1,2-dimethylbutyl, cyclopropyl, cyclopentyl, and cyclohexyl groups.

Examples of the aralkyl group represented by R² include benzyl and phenylethyl (phenethyl) groups.

Examples of the alkenyl group represented by R² include vinyl, 1-propenyl, 2-propenyl, isopropenyl, 3-butenyl, 2-butenyl, 1-butenyl, 1-methyl-2-propenyl, 1-methyl-1-propenyl, 1-ethyl-1-ethenyl, 2-methyl-2-propenyl, 2-methyl-1-propenyl, 3-methyl-2-butenyl, and 4-pentenyl groups.

Examples of the aryl group represented by R² include phenyl, 1-naphthyl, and 2-naphthyl groups.

Examples of the substituents in R¹ and R² include: alkyl groups having 1 to 6 carbon atoms; alkoxy groups having 1 to 6 carbon atoms such as methoxy, ethoxy, n-propoxy, isopropoxy, n-butoxy, isobutoxy, sec-butoxy, tert-butoxy, n-pentyloxy, isopentyloxy, n-hexyloxy, cyclopropyloxy, cyclobutyloxy, cyclopentyloxy, and cyclohexyloxy groups; alkoxycarbonyl groups having 1 to 6 carbon atoms such as methoxycarbonyl, ethoxycarbonyl, n-propoxycarbonyl, isopropoxycarbonyl, n-butoxycarbonyl, isobutoxycarbonyl, sec-butoxycarbonyl, tert-butoxycarbonyl, n-pentyloxycarbonyl, isopentyloxycarbonyl, cyclopropyloxycarbonyl, cyclobutyloxycarbonyl, and cyclopentyloxycarbonyl groups; aromatic hydrocarbon groups such as phenyl, tolyl, and naphthyl groups; halogen atoms such as fluorine, chlorine, bromine, and iodine atoms; acyl groups having 1 to 6 carbon atoms; aralkyl groups having 7 to 10 carbon atoms; aralkyloxy groups having 7 to 10 carbon atoms; alkylamino groups having 1 to 6 carbon atoms; and dialkylamino groups having an alkyl group having 1 to 6 carbon atoms.

It is preferable for R¹ to be a halogen atom, NO₃, an optionally substituted alkoxy group having 1 to 6 carbon atoms, an optionally substituted acyloxy group having 1 to 6 carbon atoms, an optionally substituted β-diketonato group having 5 to 10 carbon atoms, or a diacylmethyl group having an optionally substituted acyl group having 1 to 6 carbon atoms.

It is preferable for R² to be an optionally substituted alkyl group having 1 to 6 carbon atoms. It is preferable for M¹ to be aluminum. When M¹ is aluminum, m is preferably 3.

Specific examples of the compound (L¹) include: aluminum compounds such as aluminum nitrate, aluminum acetate, tris(2,4-pentanedionato)aluminum, trimethoxyaluminum, triethoxyaluminum, tri-n-propoxyaluminum, triisopropoxyaluminum, tri-n-butoxyaluminum, tri-sec-butoxyaluminum, and tri-tert-butoxyaluminum; titanium compounds such as tetrakis(2,4-pentanedionato)titanium, tetramethoxytitanium, tetraethoxytitanium, tetraisopropoxytitanium, tetra-n-butoxytitanium, and tetrakis(2-ethylhexoxy)titanium; and zirconium compounds such as tetrakis(2,4-pentanedionato)zirconium, tetra-n-propoxyzirconium, and tetra-n-butoxyzirconium. Among these, at least one compound selected from triisopropoxyaluminum and tri-sec-butoxyaluminum is preferred as the compound (L¹). One compound (L) may be used alone or two or more compounds (L) may be used in combination.

The proportion of the compound (L¹) in the compound (L) is not particularly limited as long as the effect of the present invention is obtained. The proportion of a compound other than the compound (L¹) in the compound (L) is preferably 20 mol% or less, more preferably 10 mol% or less, and even more preferably 5 mol% or less and may be 0 mol%, for example.

The compound (L) is hydrolyzed, so that at least some of the hydrolyzable characteristic groups possessed by the compound (L) are converted to hydroxy groups. The hydrolysate is then condensed to form a compound in which the metal atoms (M) are linked together via an oxygen atom (O). The repetitions of this condensation results in the formation of a compound that can be substantially regarded as a metal oxide. In general, the thus formed metal oxide (A) has hydroxy groups present on its surface.

A compound is categorized as the metal oxide (A) herein when the ratio, [the number of moles of the oxygen atoms (O) bonded only to the metal atoms (M)]/[the number of moles of the metal atoms (M)], is 0.8 or more in the compound. The "oxygen atom (O) bonded only to the metal atom (M)", as defined herein, refers to the oxygen atom (O) in the structure represented by M-O-M, and does not include an oxygen atom that is bonded to both the metal atom (M) and hydrogen atom (H) as is the case for the oxygen atom (O) in the structure represented by M-O-H. The above ratio in the metal oxide (A) is preferably 0.9 or more, more preferably 1.0 or more, and even more preferably 1.1 or more. The upper limit of this ratio is not particularly defined. When the valence of the metal atom (M) is denoted by n, the upper limit is typically represented by n/2.

In order for the hydrolytic condensation to take place, it is important that the compound (L) has hydrolyzable characteristic groups. When there are no such groups bonded, hydrolytic condensation reaction does not occur or proceeds very slowly, which makes difficult the preparation of the metal oxide (A) intended.

The hydrolytic condensate of the compound (L) may be produced, for example, from a particular raw material by a technique employed in commonly-known sol-gel processes. As the raw material there can be used at least one selected from the group consisting of the compound (L), a partial hydrolysate of the compound (L), a complete hydrolysate of the compound (L), a partial hydrolytic condensate of the compound (L), and a condensate formed by condensation of a part of a complete hydrolysate of the compound (L).

### [Phosphorus compound (B)]

The phosphorus compound (B) contains a moiety capable of reacting with the metal oxide (A) and typically contains two or more such moieties. It is preferable for the phosphorus compound (B) to be an inorganic phosphorus compound. It is preferable for the phosphorus compound (B) to be a compound containing 2 to 20 moieties (atomic groups or functional groups) capable of reacting with the metal oxide (A). These moieties include a moiety capable of undergoing a condensation reaction with a functional group (e.g., hydroxy group) present on the surface of the metal oxide (A). Examples of such a moiety include a halogen atom bonded directly to a phosphorus atom and an oxygen atom bonded directly to a phosphorus atom. In general, the functional group (e.g., hydroxy group) present on the surface of the metal oxide (A) is bonded to the metal atom (M) of the metal oxide (A).

Examples of the phosphorus compound (B) include: oxoacids of phosphorus such as phosphoric acid, polyphosphoric acid formed by condensation of 4 or more molecules of phosphoric acid, phosphorous acid, phosphonic acid, phosphonous acid, phosphinic acid, and phosphinous acid; salts thereof (e.g., sodium phosphate); and derivatives thereof (e.g., halides such as phosphoryl chloride and dehydrates such as phosphorus pentoxide).

One phosphorus compound (B) may be used alone or two or more phosphorus compounds (B) may be used in combination. Among the above examples of the phosphorus compound (B), phosphoric acid alone or a combination of phosphoric acid with another phosphorus compound (B) is preferably used. The use of phosphoric acid improves the stability of the first coating liquid (U) described later and the gas barrier properties and water vapor barrier properties of the resulting multilayer structure.

### [Ratio between metal oxide (A) and phosphorus compound (B)]

The multilayer structure of the present invention is one in which N_{M} and N_{P} in the layer (Y) are such as to satisfy a relationship of 0.8 ≤ N_{M}/N_{P} ≤ 4.5, preferably a relationship of 1.0 ≤ N_{M}/N_{P} ≤ 3.6, and more preferably a relationship of 1.1 ≤ N_{M}/N_{P} ≤ 3.0. If the value of N_{M}/N_{P} is more than 4.5, this means that the metal oxide (A) is excessive relative to the phosphorus compound (B). In this case, the bonding between the metal oxide (A) and the phosphorus compound (B) is insufficient, and the amount of hydroxy groups present on the surface of the metal oxide (A) is large, so that the gas barrier properties and the stability thereof tend to deteriorate. If the value of N_{M}/N_{P} is less than 0.8, this means that the phosphorus compound (B) is excessive relative to the metal oxide (A). In this case, the amount of the excess phosphorus compound (B) that is not involved in the bonding to the metal oxide (A) is large, and the amount of hydroxy groups derived from the phosphorus compound (B) is likely to be large, so that the barrier properties and the stability thereof tend to deteriorate.

The above ratio can be controlled depending on the ratio between the amount of the metal oxide (A) and the amount of the phosphorus compound (B) in the first coating liquid (U) for forming the layer (Y). The ratio between the number of moles (N_{M}) and the number of moles (N_{P}) in the layer (Y) typically corresponds to that in the first coating liquid (U) and is equal to the ratio between the number of moles of the metal atoms (M) constituting the metal oxide (A) and the number of moles of phosphorus atoms constituting the phosphorus compound (B).

### [Reaction product (D)]

A reaction product (D) is formed by a reaction between the metal oxide (A) and the phosphorus compound (B). It should be noted that a compound formed by a reaction among the metal oxide (A), the phosphorus compound (B), and another compound is also categorized as the reaction product (D). The reaction product (D) may partially include the metal oxide (A) and/or phosphorus compound (B) that has not been involved in the reaction.

### [Cations (Z)]

The ionic charge (F_{Z}) of the cations (Z) is 1 or more and 3 or less. The cations (Z) are cations containing an element in any of the second to seventh periods of the periodic table. Examples of the cations (Z) include lithium ions, sodium ions, potassium ions, magnesium ions, calcium ions, titanium ions, zirconium ions, lanthanoid ions (e.g., lanthanum ions), vanadium ions, manganese ions, iron ions, cobalt ions, nickel ions, copper ions, zinc ions, boron ions, aluminum ions, and ammonium ions, among which lithium ions, sodium ions, potassium ions, magnesium ions, calcium ions, and zinc ions are preferred. The cations (Z) may consist of one type of cations or may include two or more types of cations. The action of the cations (Z) has not yet been clarified. A possible hypothesis is that the cations (Z) interact with hydroxy groups of the metal oxide (A) or phosphorus compound (B) to prevent excessive increase in size of inorganic compound particles and thus allow the barrier layer to become denser by being filled with the reduced-size particles, consequently preventing performance degradation of the fluorescent quantum dot-containing electronic device. That is why it may be preferable to use cations capable of forming ionic bonds and having a smaller ionic charge (F_{Z}) when a greater effect on prevention of performance degradation is required.

When the cations (Z) include two or more types of cations having different ionic charges, the value of F_{Z} × N_{Z} is determined by summing up values calculated respectively for the different cations. When, for example, the cations (Z) include 1 mole of sodium ions (Na⁺) and 2 moles of calcium ions (Ca²⁺), the value of F_{Z} × N_{Z} is calculated as follows: F_{Z} × N_{Z} = 1 × 1 + 2 × 2 = 5.

The cations (Z) can be added to the layer (Y) by dissolving in the first coating liquid (U) an ionic compound (E) which releases the cations (Z) when dissolved in a solvent. Examples of counterions for the cations (Z) include: inorganic anions such as hydroxide ions, chloride ions, sulfate ions, hydrogen sulfate ions, nitrate ions, carbonate ions, and hydrogen carbonate ions; and organic acid anions such as acetate ions, stearate ions, oxalate ions, and tartrate ions. The ionic compound (E) for adding the cations (Z) may be a metal compound (Ea) or metal oxide (Eb) (different from the metal oxide (A)) which releases the cations (Z) when dissolved.

### [Ratio between metal oxide (A) and cations (Z)]

The multilayer structure of the present invention is one in which F_{Z}, N_{Z}, and N_{M} in the layer (Y) are such as to satisfy a relationship of 0.001 ≤ F_{Z} × N_{Z}/N_{M} ≤ 0.60, preferably a relationship of 0.001 ≤ F_{Z} × N_{Z}/N_{M} ≤ 0.30, and more preferably a relationship of 0.01 ≤ F_{Z} × N_{Z}/N_{M} ≤ 0.30.

### [Ratio between phosphorus compound (B) and cations (Z)]

The multilayer structure of the present invention is one in which F_{Z}, N_{Z}, and Np in the layer (Y) are preferably such as to satisfy a relationship of 0.0008 ≤ F_{Z} × N_{Z}/N_{P} ≤ 1.35, more preferably a relationship of 0.001 ≤ F_{Z} × N_{Z}/N_{P} ≤ 1.00, even more preferably a relationship of 0.0012 ≤ F_{Z} × N_{Z}/N_{P} ≤ 0.35, and particularly preferably a relationship of 0.012 ≤ F_{Z} × N_{Z}/N_{P} ≤ 0.29 in the layer (Y).

### [Polymer (C)]

The layer (Y) may further include a particular polymer (C). The polymer (C) is, for example, a polymer containing at least one functional group selected from the group consisting of a carbonyl group, a hydroxy group, a carboxyl group, a carboxylic anhydride group, and a salt of a carboxyl group.

Specific examples of the polymer (C) having a hydroxy group include: polyketones; polyvinyl alcohol polymers such as polyvinyl alcohol, modified polyvinyl alcohol containing 1 to 50 mol% of α-olefin units having 4 or less carbon atoms, and polyvinyl acetal (e.g., polyvinyl butyral); polysaccharides such as cellulose, starch, and cyclodextrin; (meth)acrylic acid polymers such as polyhydroxyethyl (meth)acrylate, poly(meth)acrylic acid, and ethylene-acrylic acid copolymer; and maleic acid polymers such as a hydrolysate of ethylene-maleic anhydride copolymer, a hydrolysate of styrene-maleic anhydride copolymer, and a hydrolysate of isobutylene-maleic anhydride alternating copolymer. Among these, the polyvinyl alcohol polymers are preferred. More specifically, polyvinyl alcohol and modified polyvinyl alcohol containing 1 to 15 mol% of α-olefin units having 4 or less carbon atoms are preferred.

The degree of saponification of the polyvinyl alcohol polymer is preferably, but not limited to, 75.0 to 99.85 mol%, more preferably 80.0 to 99.5 mol%. The viscosity-average degree of polymerization of the polyvinyl alcohol polymer is preferably 100 to 4,000 and more preferably 300 to 3,000. The viscosity of a 4 mass% aqueous solution of the polyvinyl alcohol polymer at 20°C is preferably 1.0 to 200 mPa • s and more preferably 11 to 90 mPa • s. The values of the degree of saponification, the viscosity-average degree of polymerization, and the viscosity of the 4 mass% aqueous solution are those determined according to JIS K 6726 (1994).

The polymer (C) may be a homopolymer of a monomer having a polymerizable group (e.g., vinyl acetate or acrylic acid), may be a copolymer of two or more monomers, or may be a copolymer of a monomer having a carbonyl group, a hydroxy group, and/or a carboxyl group and a monomer having none of these groups.

The molecular weight of the polymer (C) is not particularly limited. In order to obtain a multilayer structure that has better barrier properties and mechanical properties (e.g., drop impact resistance), the number average molecular weight of the polymer (C) is preferably 5,000 or more, more preferably 8,000 or more, and even more preferably 10,000 or more. The upper limit of the number average molecular weight of the polymer (C) is not particularly defined and is, for example, 1,500,000 or less.

In order to further improve the barrier properties, the content of the polymer (C) in the layer (Y) is preferably 50 mass% or less, more preferably 40 mass% or less, even more preferably 30 mass% or less, and may be 20 mass%, with respect to the mass of the layer (Y) (defined as 100 mass%). The polymer (C) may or may not react with another component in the layer (Y).

### [Additional component in layer (Y)]

The layer (Y) of the multilayer structure may include an additional component other than the metal oxide (A), the compound (L), the phosphorus compound (B), the reaction product (D), the cations (Z) or the compound (E), an acid (such as an acid catalyst used for hydrolytic condensation or an acid for deflocculation), and the polymer (C). Examples of the additional component include: metal salts of inorganic acids such as a metal carbonate, a metal hydrochloride, a metal nitrate, a metal hydrogen carbonate, a metal sulfate, a metal hydrogen sulfate, and a metal borate that do not contain the cations (Z); metal salts of organic acids such as a metal acetate, a metal stearate, a metal oxalate, and a metal tartrate that do not contain the cations (Z); layered clay compounds; crosslinking agents; polymer compounds other than the polymer (C); plasticizers; antioxidants; ultraviolet absorbers; and flame retardants. The content of the additional component in the layer (Y) of the multilayer structure is preferably 50 mass% or less, more preferably 20 mass% or less, even more preferably 10 mass% or less, and particularly preferably 5 mass% or less and may be 0 mass% (which means that the additional component is not contained), with respect to the mass of the layer (Y).

### [Thickness of layer (Y)]

The thickness of the layer (Y) (or, for a multilayer structure having two or more layers (Y), the total thickness of the layers (Y)) is preferably 0.05 to 4.0 µm and more preferably 0.1 to 2.0 µm. Thinning the layer (Y) can provide a reduction in the dimensional change of the multilayer structure which may occur during a process such as printing or lamination. Thinning the layer (Y) can also provide an increase in the flexibility of the multilayer structure, thus making it possible to allow the multilayer structure to have mechanical characteristics close to the mechanical characteristics intrinsic to the base. When the multilayer structure of the present invention includes two or more layers (Y), it is preferable for the thickness of each layer (Y) to be 0.05 µm or more in terms of the gas barrier properties. The thickness of the layer (Y) can be controlled depending on the concentration of the later-described first coating liquid (U) used for forming the layer (Y) or the method for applying the liquid (U).

### [Infrared absorption spectrum of layer (Y)]

In an infrared absorption spectrum of the layer (Y), the maximum absorption wavenumber in the region of 800 to 1,400 cm⁻¹ is preferably 1,080 to 1,130 cm⁻¹. In the process in which the metal oxide (A) and the phosphorus compound (B) react to produce the reaction product (D), there is formed a bond, represented by M-O-P, in which the metal atom (M) derived from the metal oxide (A) and the phosphorus atom (P) derived from the phosphorus compound (B) are bonded via the oxygen atom (O). As a result, a characteristic absorption band attributed to the bond appears in the infrared absorption spectrum. A study by the present inventors has revealed that the resulting multilayer structure exhibits good gas barrier properties when the absorption band attributed to the bond M-O-P is observed in the region of 1,080 to 1,130 cm⁻¹. More specifically, it has been found that the resulting multilayer structure exhibits much better gas barrier properties when the characteristic absorption band corresponds to the strongest absorption in the region of 800 to 1,400 cm⁻¹ where absorptions attributed to bonds between various atoms and oxygen atoms are generally observed.

By contrast, if a metal compound such as a metal alkoxide or metal salt and the phosphorus compound (B) are first mixed together and the mixture is then subjected to hydrolytic condensation, the resultant is a composite material in which the metal atoms derived from the metal compound and the phosphorus atoms derived from the phosphorus compound (B) have been almost homogeneously mixed and reacted. In this case, in an infrared absorption spectrum of the composite material, the maximum absorption wavenumber in the region of 800 to 1,400 cm⁻¹ falls outside the range of 1,080 to 1,130 cm⁻¹.

In the infrared absorption spectrum of the layer (Y), the half width of the maximum absorption band in the region of 800 to 1,400 cm⁻¹ is preferably 200 cm⁻¹ or less, more preferably 150 cm⁻¹ or less, even more preferably 100 cm⁻¹ or less, and particularly preferably 50 cm⁻¹ or less, in terms of the gas barrier properties of the resulting multilayer structure.

The infrared absorption spectrum of the layer (Y) can be measured by the method described in "EXAMPLES" below. If the measurement is not possible by the method described in "EXAMPLES", the measurement may be conducted by another method, examples of which include, but are not limited to: reflection spectroscopy such as reflection absorption spectroscopy, external reflection spectroscopy, or attenuated total reflection spectroscopy; and transmission spectroscopy such as Nujol method or pellet method performed on the layer (Y) scraped from the multilayer structure.

### [Layer (W)]

The multilayer structure of the present invention may further include a layer (W). The layer (W) includes a polymer (G1) having a functional group containing a phosphorus atom. It is preferable for the layer (W) to be placed contiguous to the layer (Y). That is, it is preferable that the layer (W) and the layer (Y) be arranged in contact with each other. It is also preferable for the layer (W) to be placed opposite to the base (X) across the layer (Y) (preferably on one surface of the layer (Y) opposite to that facing the base (X)). In other words, it is preferable that the layer (Y) be placed between the base (X) and the layer (W). In a preferred example, the layer (W) is placed contiguous to the layer (Y) and opposite to the base (X) across the layer (Y) (preferably on one surface of the layer (Y) opposite to that facing the base (X)). The layer (W) may further include a polymer (G2) having a hydroxy group and/or a carboxyl group. The same polymer as the polymer (C) may be used as the polymer (G2). The polymer (G1) will now be described.

### [Polymer (G1)]

Examples of the phosphorus atom-containing functional group of the polymer (G1) include a phosphoric acid group, a phosphorous acid group, a phosphonic acid group, a phosphonous acid group, a phosphinic acid group, a phosphinous acid group, salts of these groups, and functional groups derived from these groups (e.g., (partially) esterified groups, halogenated groups such as chlorinated groups, and dehydrated groups). Among these, a phosphoric acid group and/or a phosphonic acid group is preferred, and a phosphonic acid group is more preferred.

Examples of the polymer (G1) include: polymers of phosphono(meth)acrylic acid esters such as 6-[(2-phosphonoacetyl)oxy]hexyl acrylate, 2-phosphonooxyethyl methacrylate, phosphonomethyl methacrylate, 11-phosphonoundecyl methacrylate, and 1,1-diphosphonoethyl methacrylate; polymers of phosphonic acids such as vinylphosphonic acid, 2-propene-1-phosphonic acid, 4-vinylbenzylphosphonic acid, and 4-vinylphenylphosphonic acid; polymers of phosphinic acids such as vinylphosphinic acid and 4-vinylbenzylphosphinic acid; and phosphorylated starch. The polymer (G1) may be a homopolymer of a monomer having at least one of the phosphorus atom-containing functional groups or may be a copolymer of two or more such monomers. Alternatively, a mixture of two or more polymers each consisting of a single monomer may be used as the polymer (G1). In particular, a polymer of a phosphono(meth)acrylic acid ester and/or a polymer of a vinylphosphonic acid is preferred, and a polymer of a vinylphosphonic acid is more preferred. The polymer (G1) is preferably poly(vinylphosphonic acid) or poly(2-phosphonooxyethyl methacrylate) and may be poly(vinylphosphonic acid). The polymer (G1) can be obtained also by homopolymerization or copolymerization of a vinylphosphonic acid derivative such as vinylphosphonic acid halide or vinylphosphonic acid ester, followed by hydrolysis.

Alternatively, the polymer (G1) may be a copolymer of a monomer having at least one phosphorus atom-containing functional group and a vinyl monomer. Examples of the vinyl monomer copolymerizable with the monomer having a phosphorus atom-containing functional group include (meth)acrylic acid, (meth)acrylic acid esters, acrylonitrile, methacrylonitrile, styrene, nuclear-substituted styrenes, alkyl vinyl ethers, alkyl vinyl esters, perfluoroalkyl vinyl ethers, perfluoroalkyl vinyl esters, maleic acid, maleic anhydride, fumaric acid, itaconic acid, maleimide, and phenylmaleimide. Among these, (meth)acrylic acid esters, acrylonitrile, styrene, maleimide, and phenylmaleimide are preferred.

In order to obtain a multilayer structure that has better bending resistance, the proportion of the structural units derived from the monomer having a phosphorus atom-containing functional group in the total structural units of the polymer (G1) is preferably 10 mol% or more, more preferably 20 mol% or more, even more preferably 40 mol% or more, and particularly preferably 70 mol% or more, and may be 100 mol%.

The molecular weight of the polymer (G1) is not particularly limited. It is preferable that the number average molecular weight be in the range of 1,000 to 100,000. When the number average molecular weight is in this range, both a high level of improving effect of stacking of the layer (W) on bending resistance and a high level of viscosity stability of the second coating liquid (V) described later can be achieved. When the layer (Y) described is stacked, the improving effect on bending resistance is further enhanced by using the polymer (G1) whose molecular weight per phosphorus atom is in the range of 100 to 500.

The layer (W) may consist only of the polymer (G1), may consist only of the polymer (G1) and the polymer (G2), or may further include an additional component. Examples of the additional component which may be included in the layer (W) include: metal salts of inorganic acids such as a metal carbonate, a metal hydrochloride, a metal nitrate, a metal hydrogen carbonate, a metal sulfate, a metal hydrogen sulfate, and a metal borate; metal salts of organic acids such as a metal acetate, a metal stearate, a metal oxalate, and a metal tartrate; metal complexes such as a cyclopentadienyl metal complex (e.g., titanocene) and a cyanometal complex (e.g., Prussian blue); layered clay compounds; crosslinking agents; polymer compounds other than the polymer (G1) and the polymer (G2); plasticizers; antioxidants; ultraviolet absorbers; and flame retardants. The content of the additional component in the layer (W) is preferably 50 mass% or less, more preferably 20 mass% or less, even more preferably 10 mass% or less, and particularly preferably 5 mass% or less, and may be 0 mass% (which means that the additional component is not contained). The layer (W) does not include at least one of the metal oxide (A), the phosphorus compound (B), and the cations (Z). Typically, the layer (W) does not include at least the metal oxide (A).

In terms of achieving good appearance of the multilayer structure, the content of the polymer (G2) in the layer (W) is preferably 85 mass% or less, more preferably 50 mass% or less, even more preferably 20 mass% or less, and particularly preferably 10 mass% or less, with respect to the mass of the layer (W) (defined as 100 mass%). The polymer (G2) may or may not react with another component in the layer (W). The mass ratio between the polymer (G1) and the polymer (G2), as expressed by polymer (G1) : polymer (G2), is preferably in the range of 15 : 85 to 100 : 0 and more preferably in the range of 15 : 85 to 99 : 1.

It is preferable for the thickness of one layer (W) to be 0.003 µm or more, in terms of better resistance of the multilayer structure of the present invention to physical stresses (e.g., bending). The upper limit of the thickness of the layer (W) is not particularly defined; however, the improving effect on resistance to physical stresses reaches a plateau when the thickness of the layer (W) exceeds 1.0 µm. Hence, it is preferable to set the upper limit of the (total) thickness of the layer(s) (W) to 1.0 µm in terms of economic efficiency. The thickness of the layer (W) can be controlled depending on the concentration of the later-described second coating liquid (V) used for forming the layer (W) or the method for applying the liquid (V).

### [Method for producing multilayer structure]

With the production method of the present invention, the multilayer structure of the present invention can easily be produced. The features described for the multilayer structure of the present invention can be applied to the production method of the present invention and may not be described repeatedly. The features described for the production method of the present invention can be applied to the multilayer structure of the present invention.

The method of the present invention for producing a multilayer structure includes the steps [I], [II], and [III]. In the step [I], the metal oxide (A), the phosphorus compound (B), and the ionic compound (E) containing the cations (Z) are mixed to prepare the first coating liquid (U) containing the metal oxide (A), the phosphorus compound (B), and the cations (Z). In the step [II], the first coating liquid (U) is applied onto the base (X) to form a precursor layer of the layer (Y) on the base (X). In the step [III], the precursor layer is heat-treated at a temperature of 110°C or higher to form the layer (Y) on the base (X).

### [Step [I] (Preparation of first coating liquid (U))]

In the step [I], the metal oxide (A), the phosphorus compound (B), and the ionic compound (E) containing the cations (Z) are mixed. In mixing of these compounds, a solvent may be added. The cations (Z) are produced from the ionic compound (E) in the first coating liquid (U). The first coating liquid (U) may include another compound in addition to the metal oxide (A), the phosphorus compound (B), and the cations (Z).

It is preferable that N_{M} and N_{P} satisfy the relational expression given above in the first coating liquid (U). It is preferable that N_{M}, N_{Z}, and F_{Z} satisfy the relational expression given above. It is preferable that N_{P}, N_{Z}, and F_{Z} satisfy the relational expression given above.

It is preferable for the step [I] to include the following steps [I-a] to [I-c].
Step [I-a]: Step of preparing a liquid containing the metal oxide (A).
Step [I-b]: Step of preparing a solution containing the phosphorus compound (B).
Step [I-c]: Step of mixing the metal oxide (A)-containing liquid obtained in the step [I-a] and the phosphorus compound (B)-containing solution obtained in the step [I-b].

The step [I-b] may be performed either before or after the step [I-a] and may be performed simultaneously with the step [I-a]. Hereinafter, each step will be described more specifically.

In the step [I-a], a liquid containing the metal oxide (A) is prepared. The liquid is a solution or a dispersion. The liquid can be prepared, for example, by mixing the compound (L) described above, water, and optionally an acid catalyst and/or an organic solvent and subjecting the compound (L) to condensation or hydrolytic condensation in accordance with procedures employed in commonly-known sol-gel processes. When a dispersion of the metal oxide (A) is obtained by condensation or hydrolytic condensation of the compound (L), the dispersion may be subjected to a particular process (such as deflocculation as mentioned above or addition or removal of the solvent for concentration control) where necessary. The step [I-a] may include a step of subjecting at least one selected from the group consisting of the compound (L) and a hydrolysate of the compound (L) to condensation (e.g., dehydration condensation). The type of the organic solvent that can be used in the step [I-a] is not particularly limited. Preferred examples include alcohols such as methanol, ethanol, and isopropanol, water, and mixed solvents thereof. The content of the metal oxide (A) in the liquid is preferably in the range of 0.1 to 30 mass%, more preferably in the range of 1 to 20 mass%, and even more preferably in the range of 2 to 15 mass%.

For example, when the metal oxide (A) is aluminum oxide, the preparation of a dispersion of aluminum oxide is started by subjecting an aluminum alkoxide to hydrolytic condensation in an aqueous solution whose pH has optionally been adjusted with an acid catalyst, thus yielding a slurry of aluminum oxide. Next, the slurry is deflocculated in the presence of a particular amount of acid to obtain the dispersion of aluminum oxide. A dispersion of a metal oxide (A) that contains atoms of a metal other than aluminum can be produced in the same manner. Preferred examples of the acid include hydrochloric acid, sulfuric acid, nitric acid, acetic acid, lactic acid, and butyric acid. More preferred are nitric acid and acetic acid.

In the step [I-b], a solution containing the phosphorus compound (B) is prepared. The solution can be prepared by dissolving the phosphorus compound (B) in a solvent. When the solubility of the phosphorus compound (B) is low, the dissolution may be promoted by heating or ultrasonication. The solvent may be selected as appropriate depending on the type of the phosphorus compound (B). It is preferable for the solvent to include water. The solvent may include an organic solvent (e.g., methanol) as long as the organic solvent does not hinder the dissolution of the phosphorus compound (B).

The content of the phosphorus compound (B) in the phosphorus compound (B)-containing solution is preferably in the range of 0.1 to 99 mass%, more preferably in the range of 45 to 95 mass%, and even more preferably in the range of 55 to 90 mass%.

In the step [I-c], the metal oxide (A)-containing liquid and the phosphorus compound (B)-containing solution are mixed. Maintaining the temperature at 30°C or lower (e.g., at 20°C) during mixing may lead to successful preparation of the first coating liquid (U) that has good storage stability.

The compound (E) containing the cations (Z) may be added in at least one step selected from the group consisting of the step [I-a], step [I-b], and step [I-c] or in only one of these steps. For example, the compound (E) may be added to the metal oxide (A)-containing liquid prepared in the step [I-a], may be added to the phosphorus compound (B)-containing solution prepared in the step [I-b], or may be added to the liquid mixture prepared by mixing the metal oxide (A)-containing liquid and the phosphorus compound (B)-containing solution in the step [I-c].

Furthermore, the first coating liquid (U) may contain the polymer (C). The method for having the polymer (C) contained in the first coating liquid (U) is not particularly limited. For example, a solution of the polymer (C) may be added to and mixed with any of the metal oxide (A)-containing liquid, the phosphorus compound (B)-containing solution, and the liquid mixture thereof. Alternatively, a powder or pellet of the polymer (C) may be added to and then dissolved in any of the metal oxide (A)-containing liquid, the phosphorus compound (B)-containing solution, and the liquid mixture thereof. When the polymer (C) is contained in the phosphorus compound (B)-containing solution, the rate of reaction between the metal oxide (A) and the phosphorus compound (B) is slowed during the mixing of the metal oxide (A)-containing liquid and the phosphorus compound (B)-containing solution, with the result that the first coating liquid (U) that is superior in temporal stability may be obtained.

The first coating liquid (U) may contain at least one acid compound (J) selected from hydrochloric acid, nitric acid, acetic acid, trifluoroacetic acid, and trichloroacetic acid where necessary. The content of the acid compound (J) is preferably in the range of 0.1 to 5.0 mass% and more preferably in the range of 0.5 to 2.0 mass%. When the content is in such a range, the addition of the acid compound (J) exerts a beneficial effect, and the removal of the acid compound (J) is easy. If any acid component remains in the metal oxide (A)-containing liquid, the amount of the acid compound (J) to be added may be determined in consideration of the amount of the remaining acid component.

The liquid mixture obtained in the step [I-c] can be used per se as the first coating liquid (U). In this case, it is usual that the solvent contained in the metal oxide (A)-containing liquid or the phosphorus compound (B)-containing solution serves as the solvent of the first coating liquid (U). Alternatively, the first coating liquid (U) may be prepared by subjecting the liquid mixture to a process such as addition of an organic solvent, adjustment of pH, adjustment of viscosity, or addition of an additive. Examples of the organic solvent include the solvent used in the preparation of the phosphorus compound (B)-containing solution.

In terms of the storage stability of the first coating liquid (U) and the performance of the first coating liquid (U) in its application onto the base (X), the solids concentration in the first coating liquid (U) is preferably in the range of 1 to 20 mass%, more preferably in the range of 2 to 15 mass%, and even more preferably in the range of 3 to 10 mass%. The solids concentration in the first coating liquid (U) can be determined as follows, for example: A given amount of the first coating liquid (U) was put in a petri dish, the first coating liquid (U) was heated together with the petri dish to remove a volatile component such as the solvent, and the mass of the remaining solids is divided by the mass of the first coating liquid (U) initially put in the dish.

The viscosity of the first coating liquid (U), as measured with a Brookfield rotary viscometer (SB-type viscometer: Rotor No. 3, Rotational speed = 60 rpm), is preferably 3,000 mPa • s or less, more preferably 2,500 mPa • s or less, and even more preferably 2,000 mPa • s or less at a temperature at which the first coating liquid (U) is applied. With the thus-measured viscosity being 3,000 mPa • s or less, the leveling of the first coating liquid (U) is high, and thus the resulting multilayer structure can have better appearance. The viscosity of the first coating liquid (U) is preferably 50 mPa • s or more, more preferably 100 mPa • s or more, and even more preferably 200 mPa • s or more.

In the first coating liquid (U), N_{M} and N_{P} satisfy a relationship of 0.8 ≤ N_{M}/N_{P} ≤ 4.5. In the first coating liquid (U), N_{M}, N_{Z}, and F_{Z} satisfy a relationship of 0.001 ≤ F_{Z} × N_{Z}/N_{M} ≤ 0.60. It is preferable that, in the first coating liquid (U), F_{Z}, N_{Z}, and Np satisfy a relationship of 0.0008 ≤ F_{Z} × N_{Z}/N_{P} ≤ 1.35.

### [Step [II] (Application of first coating liquid (U))]

In the step [II], the first coating liquid (U) is applied onto the base (X) to form a precursor layer of the layer (Y) on the base (X). The first coating liquid (U) may be applied directly onto at least one surface of the base (X). Before application of the first coating liquid (U), an adhesive layer (H) may be formed on the surface of the base (X), for example, by treating the surface of the base (X) with a commonly-known anchor coating agent or by applying a commonly-known adhesive to the surface of the base (X).

The method for applying the first coating liquid (U) onto the base (X) is not particularly limited, and any commonly-known method can be used. Examples of the application method include casting, dipping, roll coating, gravure coating, screen printing, reverse coating, spray coating, kiss coating, die coating, metering bar coating, chamber doctor-using coating, and curtain coating.

In the step [II], the formation of the precursor layer of the layer (Y) is accomplished typically by removing the solvent from the first coating liquid (U). The method for removing the solvent is not particularly limited, and any commonly-known drying method can be employed. Examples of the drying method include hot-air drying, heat roll contact drying, infrared heating, and microwave heating. The temperature of the drying treatment is preferably 0 to 15°C or more lower than the onset temperature of fluidization of the base (X). When the first coating liquid (U) contains the polymer (C), the temperature of the drying treatment is preferably 15 to 20°C or more lower than the onset temperature of pyrolysis of the polymer (C). The temperature of the drying treatment is preferably in the range of 70 to 200°C, more preferably in the range of 80 to 180°C, and even more preferably in the range of 90 to 160°C. The removal of the solvent may be performed either at ordinary pressure or at reduced pressure. Alternatively, the solvent may be removed by the heat treatment in the step [III] described later.

When the layers (Y) are stacked on both surfaces of the base (X) that is in the form of a layer, a first layer (a precursor layer of a first layer (Y)) may be formed by application of the first coating liquid (U) onto one surface of the base (X) followed by removal of the solvent, and then a second layer (a precursor layer of a second layer (Y)) may be formed by application of the first coating liquid (U) onto the other surface of the base (X) followed by removal of the solvent. The composition of the first coating liquid (U) applied may be the same for both of the surfaces or may be different for each surface.

### [Step [III] (Treatment of precursor layer of layer (Y))]

In the step [III], the precursor layer (precursor layer of the layer (Y)) formed in the step [II] is heat-treated at a temperature of 140°C or higher to form the layer (Y). The temperature of this heat treatment is preferably higher than the temperature of the drying treatment subsequent to the application of the first coating liquid (U).

In the step [III], a reaction takes place in which pieces of the metal oxide (A) are bonded together via phosphorus atoms (phosphorus atoms derived from the phosphorus compound (B)). From another standpoint, a reaction of formation of the reaction product (D) takes place in the step [III]. In order for the reaction to take place to a sufficient extent, the temperature of the heat treatment is preferably 140°C or higher, more preferably 170°C or higher, and even more preferably 180°C or higher. A lowered temperature of the heat treatment increases the time required to achieve a sufficient degree of reaction, and may cause a reduction in production efficiency. The preferred upper limit of the temperature of the heat treatment varies depending on, for example, the type of the base (X). For example, when a thermoplastic resin film made of polyamide resin is used as the base (X), it is preferable for the temperature of the heat treatment to be 270°C or lower. When a thermoplastic resin film made of polyester resin is used as the base (X), it is preferable for the temperature of the heat treatment to be 240°C or lower. The heat treatment can be performed, for example, in air, in a nitrogen atmosphere, or in an argon atmosphere.

The length of time of the heat treatment is preferably in the range of 0.1 seconds to 1 hour, more preferably in the range of 1 second to 15 minutes, and even more preferably in the range of 5 to 300 seconds.

The method of the present invention for producing a multilayer structure may include a step of irradiating the layer (Y) or the precursor layer of the layer (Y) with ultraviolet light. The ultraviolet irradiation may be performed, for example, after the step [II] (for example, after the removal of the solvent from the applied first coating liquid (U) is almost completed).

To place the adhesive layer (H) between the base (X) and the layer (Y), a surface of the base (X) may be treated with a commonly-known anchor coating agent, or a commonly-known adhesive may be applied to a surface of the base (X), before application of the first coating liquid (U).

The method of the present invention for producing a multilayer structure may further include the steps [i] and [ii]. In the step [i], the second coating liquid (V) including the polymer (G1) containing a phosphorus atom and a solvent is prepared. In the step [ii], the layer (W) placed contiguous to the layer (Y) is formed using the second coating liquid (V). There is no particular limitation on when the step [i] is done. The step [i] may be performed concurrently with the step [I], [II], or [III] or may be performed after the step [I], [II], or [III]. The step [ii] can be performed after the step [II] or [III]. The layer (W) stacked on the layer (Y) so as to be in contact with the layer (Y) can be formed by applying the second coating liquid (V) to the layer (Y) or the precursor layer of the layer (Y). When the layer (W) including the polymer (G2) is to be formed, the second coating liquid (V) should contain the polymer (G2). In the second coating liquid (V), the mass ratio between the polymer (G1) and the polymer (G2), as expressed by polymer (G1) : polymer (G2), is preferably in the range of 15 : 85 to 100 : 0 and more preferably in the range of 15 : 85 to 99 : 1. The use of the second coating liquid (V) containing the polymer (G1) and the polymer (G2) at such a mass ratio allows the formation of the layer (W) in which the mass ratio between the polymer (G1) and the polymer (G2) is within the range. The second coating liquid (V) can be prepared by dissolving the polymer (G1) (and optionally the polymer (G2)) in a solvent.

The solvent used in the second coating liquid (V) may be selected as appropriate depending on the type(s) of the polymer(s) to be contained in the liquid. Preferred are water, alcohols, and mixed solvents thereof. As long as the dissolution of the polymer(s) is not hindered, the solvent may include: an ether such as tetrahydrofuran, dioxane, trioxane, or dimethoxyethane; a ketone such as acetone or methyl ethyl ketone; a glycol such as ethylene glycol or propylene glycol; a glycol derivative such as methyl cellosolve, ethyl cellosolve, or n-butyl cellosolve; glycerin; acetonitrile; an amide such as dimethylformamide; dimethyl sulfoxide; and/or sulfolane.

The concentration of the solids (such as the polymer (G1)) in the second coating liquid (V) is preferably in the range of 0.01 to 60 mass%, more preferably in the range of 0.1 to 50 mass%, and even more preferably in the range of 0.2 to 40 mass%, in terms of the storage stability and coating properties of the liquid. The solids concentration can be determined in the same manner as described for the first coating liquid (U).

In the step [ii], the formation of the layer (W) is accomplished typically by removing the solvent from the second coating liquid (V). The method for removing the solvent from the second coating liquid (V) is not particularly limited, and any commonly-known drying method can be employed. Examples of the drying method include hot-air drying, heat roll contact drying, infrared heating, and microwave heating. The drying temperature is preferably 0 to 15°C or more lower than the onset temperature of fluidization of the base (X). The drying temperature is preferably in the range of 70 to 200°C and more preferably in the range of 150 to 200°C. The removal of the solvent may be performed either at ordinary pressure or at reduced pressure. When the step [ii] is performed between the step [II] and step [III] previously described, the solvent may be removed by the heat treatment in the step [III].

The layers (W) may be formed on both sides of the base (X), with the layers (Y) interposed therebetween. In an exemplary case, a first layer (W) is formed by application of the second coating liquid (V) on one side followed by removal of the solvent. Next, a second layer (W) is formed by application of the second coating liquid (V) on the other side followed by removal of the solvent. The composition of the second coating liquid (V) applied may be the same for both sides or may be different for each side.

A multilayer structure obtained as a result of the heat treatment in the step [III] can be used per se as the multilayer structure of the present invention. As previously described, however, another member (e.g., an additional layer) may be attached to or formed on the multilayer structure obtained as a result of the heat treatment in the step [III], and the resulting layered product may be used as the multilayer structure of the present invention. The attachment of the member can be done by a commonly-known method.

### [Adhesive layer (H)]

In the multilayer structure of the present invention, the layer (Y) may be stacked in direct contact with the base (X). Alternatively, the layer (Y) may be stacked above the base (X), with another layer interposed therebetween. For example, the layer (Y) may be stacked above the base (X), with the adhesive layer (H) interposed therebetween. With this configuration, the adhesion between the base (X) and the layer (Y) may be enhanced. The adhesive layer (H) may be formed from an adhesive resin. The adhesive layer (H) made of an adhesive resin can be formed by treating a surface of the base (X) with a commonly-known anchor coating agent or by applying a commonly-known adhesive to a surface of the base (X). The adhesive is preferably a two-component reactive polyurethane adhesive including a polyisocyanate component and a polyol component which are to be mixed and reacted. The addition of a small amount of additive such as a commonly-known silane coupling agent to the anchor coating agent or adhesive may further enhance the adhesion. Examples of the silane coupling agent include, but are not limited to, silane coupling agents having a reactive group such as an isocyanate, epoxy, amino, ureido, or mercapto group. Strong adhesion between the base (X) and the layer (Y) via the adhesive layer (H) makes it possible to more effectively prevent deterioration in the barrier properties and appearance of the multilayer structure of the present invention when the multilayer structure is subjected to a process such as printing or lamination. The thickness of the adhesive layer (H) is preferably 0.01 to 10.0 µm and more preferably 0.03 to 5.0 µm.

### [Additional layer]

The multilayer structure of the present invention may include an additional layer for imparting various properties such as heat-sealing properties or for improving the barrier properties or mechanical properties. Such a multilayer structure of the present invention can be formed, for example, by stacking the layer (Y) on the base (X) directly or with the adhesive layer (H) interposed therebetween and then attaching or forming the additional layer on the layer (Y) directly or with the adhesive layer (H) interposed therebetween. Examples of the additional layer include, but are not limited to, an ink layer and a polyolefin layer.

The multilayer structure of the present invention may include an ink layer on which a product name or a decorative pattern is to be printed. Such a multilayer structure of the present invention can be produced, for example, by stacking the layer (Y) on the base (X) directly or with the adhesive layer (H) interposed therebetween and then forming the ink layer directly on the layer (Y). Examples of the ink layer include a film resulting from drying of a liquid prepared by dispersing a polyurethane resin containing a pigment (e.g., titanium dioxide) in a solvent. The ink layer may be a film resulting from drying of an ink or electronic circuit-forming resist containing a polyurethane resin free of any pigment or another resin as a main component. Methods that can be used to apply the ink layer onto the layer (Y) include gravure printing and various coating methods using a wire bar, a spin coater, or a die coater. The thickness of the ink layer is preferably 0.5 to 10.0 µm and more preferably 1.0 to 4.0 µm.

When the multilayer structure of the present invention includes the layer (W) that contains the polymer (G2), the adhesion between the layer (W) and another layer such as the adhesive layer (H) or the additional layer (e.g., the ink layer) is improved by virtue of the polymer (G2) having a functional group with high affinity to said another layer. This enables the multilayer structure to maintain its barrier performance after being exposed to physical stresses such as that caused by a stretching process and can prevent the multilayer structure from suffering from an appearance defect such as delamination.

When a polyolefin layer is placed as an outermost layer of the multilayer structure of the present invention, heat-sealing properties can be imparted to the multilayer structure, or the mechanical characteristics of the multilayer structure can be improved. In terms of, for example, the impartation of heat-sealing properties and the improvement in mechanical characteristics, the polyolefin is preferably polypropylene or polyethylene. It is also preferable to stack at least one film selected from the group consisting of a film made of a polyester, a film made of a polyamide, and a film made of a hydroxy group-containing polymer, in order to improve the mechanical characteristics of the multilayer structure. In terms of the improvement in mechanical characteristics, the polyester is preferably polyethylene terephthalate, the polyamide is preferably nylon-6, and the hydroxy group-containing polymer is preferably ethylene-vinyl alcohol copolymer. Between the layers there may be provided an anchor coat layer or a layer made of an adhesive where necessary.

### [Configuration of multilayer structure]

Specific examples of the configuration of the multilayer structure of the present invention are listed below. The multilayer structure may have an adhesive layer such as the adhesive layer (H); however, the adhesive layer is omitted in the following list of specific examples.
(1) Layer (Y)/polyester layer,
(2) Layer (Y)/polyester layer/layer (Y),
(3) Layer (Y)/polyamide layer,
(4) Layer (Y)/polyamide layer/layer (Y),
(5) Layer (Y)/polyolefin layer,
(6) Layer (Y)/polyolefin layer/layer (Y),
(7) Layer (Y)/hydroxy group-containing polymer layer,
(8) Layer (Y)/hydroxy group-containing polymer layer/layer (Y),
(9) Layer (Y)/inorganic deposited layer/polyester layer,
(10) Layer (Y)/inorganic deposited layer/polyamide layer,
(11) Layer (Y)/inorganic deposited layer/polyolefin layer,
(12) Layer (Y)/inorganic deposited layer/hydroxy group-containing polymer layer,
(13) Layer (Y)/polyester layer/polyamide layer/polyolefin layer,
(14) Layer (Y)/polyester layer/layer (Y)/polyamide layer/polyolefin layer,
(15) Polyester layer/layer (Y)/polyamide layer/polyolefin layer,
(16) Layer (Y)/polyamide layer/polyester layer/polyolefin layer,
(17) Layer (Y)/polyamide layer/layer (Y)/polyester layer/polyolefin layer,
(18) Polyamide layer/layer (Y)/polyester layer/polyolefin layer,
(19) Layer (Y)/polyolefin layer/polyamide layer/polyolefin layer,
(20) Layer (Y)/polyolefin layer/layer (Y)/polyamide layer/polyolefin layer,
(21) Polyolefin layer/layer (Y)/polyamide layer/polyolefin layer,
(22) Layer (Y)/polyolefin layer/polyolefin layer,
(23) Layer (Y)/polyolefin layer/layer (Y)/polyolefin layer,
(24) Polyolefin layer/layer (Y)/polyolefin layer,
(25) Layer (Y)/polyester layer/polyolefin layer,
(26) Layer (Y)/polyester layer/layer (Y)/polyolefin layer,
(27) Polyester layer/layer (Y)/polyolefin layer,
(28) Layer (Y)/polyamide layer/polyolefin layer,
(29) Layer (Y)/polyamide layer/layer (Y)/polyolefin layer,
(30) Polyamide layer/layer (Y)/polyolefin layer,
(31) Inorganic deposited layer/layer (Y)/polyester layer,
(32) Inorganic deposited layer/layer (Y)/polyester layer/layer (Y)/inorganic deposited layer,
(33) Inorganic deposited layer/layer (Y)/polyamide layer,
(34) Inorganic deposited layer/layer (Y)/polyamide layer/layer (Y)/inorganic deposited layer,
(35) Inorganic deposited layer/layer (Y)/polyolefin layer,
(36) Inorganic deposited layer/layer (Y)/polyolefin layer/layer (Y)/inorganic deposited layer

### EXAMPLES

Hereinafter, the present invention will be described in more detail by way of examples. However, the present invention is not limited by these examples in any respect, and it should be understood that many modifications can be made by any ordinarily skilled person in the art within the technical concept of the present invention. Analysis and evaluation in Examples and Comparative Examples given below were performed as will now be described.

### (1) Infrared absorption spectrum of layer (Y)

The measurement was performed by attenuated total reflection spectroscopy using a Fourier transform infrared spectrophotometer. The measurement conditions were as follows.
Apparatus: Spectrum One, manufactured by PerkinElmer, Inc.
Measurement mode: Attenuated total reflection spectroscopy
Measurement range: 800 to 1,400 cm⁻¹

### (2) Measurement of respective thicknesses of layers

The multilayer structure was cut using a focused ion beam (FIB) to prepare a section (thickness: 0.3 µm) for cross-sectional observation. The prepared section was secured to a sample stage with a carbon tape and subjected to platinum ion sputtering at an accelerating voltage of 30 kV for 30 seconds. The cross-section of the multilayer structure was observed using a field-emission transmission electron microscope to determine the respective thicknesses of the layers. The measurement conditions were as follows.
Apparatus: JEM-2100F, manufactured by JEOL Ltd.
Accelerating voltage: 200 kV
Magnification: × 250,000

### (3) Quantification of metal ions

An amount of 5 mL of a high-purity nitric acid of analytical grade was put on 1.0 g of the multilayer structure, which was subjected to microwave decomposition. The resulting solution was adjusted in volume to 50 mL with ultrapure water to obtain a solution for quantitative analysis of metal ions other than aluminum ions. In addition, 0.5 mL of this solution was adjusted in volume to 50 mL with ultrapure water to obtain a solution for quantitative analysis of aluminum ions. The amounts of various metal ions contained in the solution obtained as above were determined by an internal reference method using an inductively coupled plasma emission spectrometer. The lower detection limit was 0.1 ppm for all of the metal ions. The measurement conditions were as follows.
Apparatus: Optima 4300DV, manufactured by PerkinElmer, Inc.
RF power: 1,300 W
Pump flow rate: 1.50 mL/min
Flow rate of auxiliary gas (argon): 0.20 L/min
Flow rate of carrier gas (argon): 0.70 L/min
Coolant gas: 15.0 L/min

### (4) Quantification of ammonium ions

The multilayer structure was cut into a piece with a size of 1 cm × 1 cm, which was frozen and crushed. The resulting powder was sieved with a sieve with a nominal size of 1 mm (complying with the normal sieve standards JIS Z 8801-1 to 3). An amount of 10 g of the powder fraction having passed through the sieve was dispersed in 50 mL of ion-exchanged water, and the dispersion was subjected to extraction operation at 95°C for 10 hours. The amount of ammonium ions contained in the resulting extract was determined using a cation chromatography apparatus. The lower detection limit was 0.02 ppb. The measurement conditions were as follows.
Apparatus: ICS-1600, manufactured by Dionex Corporation
Guard column: IonPAC CG-16 (5 mm Dia. × 50 mm), manufactured by Dionex Corporation
Separation column: IonPAC CS-16 (5 mm Dia. × 250 mm), manufactured by Dionex Corporation
Detector: Electrical conductivity detector
Eluent: 30 mmol/L aqueous methanesulfonic acid solution
Temperature: 40°C
Flow rate of eluent: 1 mL/min
Analyzed volume: 25 pL

### (5) Measurement of oxygen transmission rate

A sample was set to an oxygen transmission testing apparatus in such a manner that the layer as the base faced the carrier gas side, and the oxygen transmission rate was measured by an equal pressure method. The measurement conditions were as follows.
Apparatus: MOCON OX-TRAN 2/20, manufactured by ModernControls, Inc.
Temperature: 20°C
Humidity on oxygen feed side: 85% RH
Humidity on carrier gas side: 85% RH
Oxygen pressure: 1 atmosphere
Carrier gas pressure: 1 atmosphere

### (6) Measurement of water vapor transmission rate (equal pressure method)

A sample was set to a water vapor transmission testing apparatus in such a manner that the layer as the base faced the carrier gas side, and the moisture permeability (water vapor transmission rate) was measured by an equal pressure method. The measurement conditions were as follows.
Apparatus: MOCON PERMATRAN W3/33, manufactured by ModernControls, Inc.
Temperature: 40°C
Humidity on water vapor feed side: 90% RH
Humidity on carrier gas side: 0% RH

### (7) Measurement of water vapor transmission rate (differential pressure method) (Measurement of moisture permeability in Examples 1-36 to 1-39 and Comparative Example 1-7)

A sample was set to a water vapor transmission testing apparatus in such a manner that the layer as the base faced the water vapor feed side, and the moisture permeability (water vapor transmission rate) was measured by a differential pressure method. The measurement conditions were as follows.
Apparatus: Deltaperm, manufactured by Technolox Ltd.
Temperature: 40°C
Pressure on water vapor feed side (upper chamber): 50 Torr (6,665 Pa)
Pressure on water vapor transmission side (lower chamber): 0.003 Torr (0.4 Pa)

### <Synthesis example of polymer (G1-1)>

Under nitrogen atmosphere, 8.5 g of 2-phosphonooxyethyl methacrylate and 0.1 g of azobisisobutyronitrile were dissolved in 17 g of methyl ethyl ketone and the resulting solution was stirred at 80°C for 12 hours. The polymer solution obtained was cooled and then added to 170 g of 1,2-dichloroethane. This was followed by decantation to collect a polymer formed as a precipitate. Subsequently, the polymer was dissolved in tetrahydrofuran, and the solution was subjected to purification by reprecipitation using 1,2-dichloroethane as a poor solvent. The purification by reprecipitation was repeated three times, followed by vacuum drying at 50°C for 24 hours to obtain a polymer (G1-1). The polymer (G1-1) was a polymer of 2-phosphonooxyethyl methacrylate. As a result of GPC analysis, the number average molecular weight of the polymer was determined to be 10,000 on a polystyrene-equivalent basis.

### <Synthesis example of polymer (G1-2)>

Under nitrogen atmosphere, 10 g of vinylphosphonic acid and 0.025 g of 2,2'-azobis(2-amidinopropane) dihydrochloride were dissolved in 5 g of water, and the resulting solution was stirred at 80°C for 3 hours. After being cooled, the polymer solution was diluted by the addition of 15 g of water and then filtered using "Spectra/Por" (registered trademark), a cellulose membrane, manufactured by Spectrum Laboratories, Inc. Water was removed from the filtrate by distillation, followed by vacuum drying at 50°C for 24 hours to obtain a polymer (G1-2). The polymer (G1-2) was poly(vinylphosphonic acid). As a result of GPC analysis, the number average molecular weight of the polymer was determined to be 10,000 on a polyethylene glycol-equivalent basis.

### <Production example of first coating liquid (U-1)>

Distilled water in an amount of 230 parts by mass was heated to 70°C under stirring. Triisopropoxy aluminum in an amount of 88 parts by mass was added dropwise to the distilled water over 1 hour, the liquid temperature was gradually increased to 95°C, and isopropanol generated was distilled off. In this manner, hydrolytic condensation was performed. To the obtained liquid was added 4.0 parts by mass of a 60 mass% aqueous nitric acid solution, and this was followed by stirring at 95°C for 3 hours to deflocculate the agglomerates of the particles of the hydrolytic condensate. After that, 2.24 parts by mass of an aqueous sodium hydroxide solution with a concentration of 1.0 mol% was added to the liquid, which was then concentrated so that the solids concentration was adjusted to 10 mass% in terms of aluminum oxide. To 18.66 parts by mass of the thus obtained liquid were added 58.19 parts by mass of distilled water, 19.00 parts by mass of methanol, and 0.50 parts by mass of a 5 mass% aqueous polyvinyl alcohol solution (PVA 124, manufactured by KURARAY CO., LTD.; degree of saponification = 98.5 mol%, viscosity-average degree of polymerization = 2,400, viscosity of 4 mass% aqueous solution at 20°C = 60 mPa • s), and this was followed by stirring to achieve homogeneity. A dispersion as a metal oxide (A)-containing liquid was thus obtained. Subsequently, 3.66 parts by mass of an 85 mass% aqueous phosphoric acid solution as a phosphorus compound (B)-containing solution was added dropwise to the dispersion under stirring, with the liquid temperature held at 15°C. The stirring was continued further for 30 minutes after completion of the dropwise addition, thus yielding the intended first coating liquid (U-1) for which the values of N_{M}/N_{P}, F_{Z} × N_{Z}/N_{M}, and F_{Z} × N_{Z}/N_{P} were as shown in Table 1.

### <Production examples of first coating liquids (U-2) to (U-5)>

In the preparation of first coating liquids (U-2) to (U-5), the amount of the 1.0 mol% aqueous sodium hydroxide solution added for the preparation of a dispersion was changed so that the values of F_{Z} × N_{Z}/N_{M} and F_{Z} × N_{Z}/N_{P} were adjusted to those shown in Table 1 given below. Except for this difference, the first coating liquids (U-2) to (U-5) were prepared in the same manner as in the preparation of the first coating liquid (U-1).

### <Production example of first coating liquid (U-6)>

In the preparation of a first coating liquid (U-6), the aqueous sodium hydroxide solution was not added and the amount of the distilled water added (which was 58.19 parts by mass in the preparation of the first coating liquid (U-1)) was changed to 58.09 parts by mass for the preparation of a dispersion. Furthermore, the dropwise addition of the aqueous phosphoric acid solution to the dispersion was followed by addition of 0.10 parts by mass of a 1.0 mol% aqueous sodium hydroxide solution. Except for these differences, the first coating liquid (U-6) was prepared in the same manner as in the preparation of the first coating liquid (U-1).

### <Production example of first coating liquid (U-8)>

A first coating liquid (U-8) was prepared in the same manner as in the preparation of the first coating liquid (U-5), except for using trimethyl phosphate instead of phosphoric acid in the phosphorus compound (B)-containing solution.

### <Production example of first coating liquid (U-9)>

A first coating liquid (U-9) was prepared in the same manner as in the preparation of the first coating liquid (U-5), except for using a 5 mass% aqueous polyacrylic acid solution instead of the 5 mass% aqueous polyvinyl alcohol solution for the preparation of a dispersion.

### <Production examples of first coating liquids (U-7) and (U-10) to (U-18)>

First coating liquids (U-7) and (U-10) to (U-18) were prepared in the same manner as in the preparation of the first coating liquid (U-5), except for using aqueous solutions of various metal salts instead of the 1.0 mol% aqueous sodium hydroxide solution for the preparation of a dispersion. The aqueous metal salt solution used was a 1.0 mol% aqueous sodium chloride solution for the first coating liquid (U-7), a 1.0 mol% aqueous lithium hydroxide solution for the first coating liquid (U-10), a 1.0 mol% aqueous potassium hydroxide solution for the first coating liquid (U-11), a 0.5 mol% aqueous calcium chloride solution for the first coating liquid (U-12), a 0.5 mol% aqueous cobalt chloride solution for the first coating liquid (U-13), a 0.5 mol% aqueous zinc chloride solution for the first coating liquid (U-14), a 0.5 mol% aqueous magnesium chloride solution for the first coating liquid (U-15), a 1.0 mol% aqueous ammonia for the first coating liquid (U-16), an aqueous salt solution (a mixture of a 1.0 mol% aqueous sodium chloride solution and a 0.5 mol% aqueous calcium chloride solution) for the first coating liquid (U-17), and an aqueous salt solution (a mixture of a 0.5 mol% aqueous zinc chloride solution and a 0.5 mol% aqueous calcium chloride solution) for the first coating liquid (U-18).

### <Production examples of first coating liquids (U-19) to (U-23)>

First coating liquids (U-19) to (U-23) were prepared in the same manner as in the preparation of the first coating liquid (U-5), except for changing the ratios N_{M}/N_{P} and F_{Z} × N_{Z}/N_{P} in accordance with Table 1 given below.

### <Production examples of first coating liquids (U-34), (U-36), (U-37), (U-39), and (CU-5)>

The following were used instead of the aqueous sodium hydroxide solution for the preparation of a dispersion: 0.19 parts by mass of zinc oxide for a first coating liquid (U-34); 0.19 parts by mass of magnesium oxide for a first coating liquid (U-36); 0.38 parts by mass of boric acid for a first coating liquid (U-37); 0.30 parts by mass of calcium carbonate for a first coating liquid (U-39); and 0.38 parts by mass of tetraethoxysilane for a first coating liquid (CU-5). These were all added after the addition of the aqueous polyvinyl alcohol solution. Furthermore, the amount of distilled water added, which was 58.19 parts by mass in the preparation of the first coating liquid (U-1), was 58.00 parts by mass for the first coating liquid (U-34) and the first coating liquid (U-36), 57.89 parts by mass for the first coating liquid (U-39), and 57.81 parts by mass for the first coating liquid (U-37) and the first coating liquid (CU-5). Except for these changes, the first coating liquids (U-34), (U-36), (U-37), (U-39), and (CU-5) were prepared in the same manner as in the preparation of the first coating liquid (U-1).

### <Production example of first coating liquid (CU-1)>

A first coating liquid (CU-1) was prepared in the same manner as in the preparation of the first coating liquid (U-1), except that the 1.0 mol% aqueous sodium hydroxide solution was not added for the preparation of a dispersion.

### <Production examples of first coating liquids (CU-2) and (CU-6)>

First coating liquids (CU-2) and (CU-6) were prepared in the same manner as in the preparation of the first coating liquid (U-1), except for changing the amount of the 1.0 mol% aqueous sodium hydroxide solution added for the preparation of a dispersion so that the values of F_{Z} × N_{Z}/N_{M} were adjusted to those shown in Table 1.

### <Production examples of first coating liquids (CU-3) and (CU-4)>

First coating liquids (CU-3) and (CU-4) were prepared in the same manner as in the preparation of the first coating liquid (U-5), except that the values of N_{M}/N_{P} were adjusted in accordance with Table 1.

### <Production examples of second coating liquids (V-1) to (V-6)>

First, the polymer (G1-1) as obtained in the synthesis example was dissolved in a mixed solvent of water and methanol (mass ratio of water : methanol = 7 : 3) to obtain a second coating liquid (V-1) with a solids concentration of 1 mass% There was also prepared a mixture containing 91 mass% of the polymer (G1-1) as obtained in the synthesis example and 9 mass% of polyvinyl alcohol (PVA 124, manufactured by KURARAY CO., LTD.; degree of saponification = 98.5 mol%, viscosity-average degree of polymerization = 2,400, viscosity of 4 mass% aqueous solution at 20°C = 60 mPa•s). This mixture was dissolved in a mixed solvent of water and methanol (mass ratio of water : methanol = 7 : 3) to obtain a second coating liquid (V-2) with a solids concentration of 1 mass%. Furthermore, there was prepared a mixture containing 91 mass% of the polymer (G1-1) as obtained in the synthesis example and 9 mass% of polyacrylic acid (number average molecular weight = 210,000, weight average molecular weight = 1,290,000). This mixture was dissolved in a mixed solvent of water and methanol (mass ratio of water : methanol = 7 : 3) to obtain a second coating liquid (V-3) with a solids concentration of 1 mass%. In addition, second coating liquids (V-4) to (V-6) were obtained in the same manner as in the preparation of the second coating liquids (V-1) to (V-3), except for replacing the polymer (G1-1) by the polymer (G1-2).

The details of films used in Examples and Comparative Examples were as follows.
1) PET 12: Oriented polyethylene terephthalate film; "Lumirror P60" (trade name), manufactured by TORAY INDUSTRIES, INC. and having a thickness of 12 µm)
2) PET 125: Oriented polyethylene terephthalate film; "Lumirror S10" (trade name), manufactured by TORAY INDUSTRIES, INC. and having a thickness of 125 µm)
3) PET 50: Polyethylene terephthalate film with improved adhesion to ethylene-vinyl acetate copolymer; "SHINEBEAM Q1A15" (trade name), manufactured by TOYOBO CO., LTD. and having a thickness of 50 µm)
4) ONY: Oriented nylon film; "EMBLEM ONBC" (trade name), manufactured by UNITIKA LTD. and having a thickness of 15 µm)
5) CPP 50: Non-oriented polypropylene film; "RXC-21" (trade name), manufactured by Mitsui Chemicals Tohcello, Inc. and having a thickness of 50 µm)
6) CPP 60: Non-oriented polypropylene film; "RXC-21" (trade name), manufactured by Mitsui Chemicals Tohcello, Inc. and having a thickness of 60 µm)
7) CPP 70: Non-oriented polypropylene film; "RXC-21" (trade name), manufactured by Mitsui Chemicals Tohcello, Inc. and having a thickness of 70 µm)
8) CPP 100: Non-oriented polypropylene film; "RXC-21" (trade name), manufactured by Mitsui Chemicals Tohcello, Inc. and having a thickness of 100 µm)

### [Example 1] <Example 1-1>

First, a PET 12 was prepared as the base (X). The first coating liquid (U-1) was applied onto this base using a bar coater in such a manner that the dry thickness would be 0.5 µm, and the applied film was dried at 100°C for 5 minutes to form a precursor layer of the layer (Y) on the base. This was followed by heat treatment at 180°C for 1 minute to form the layer (Y). In this way, a multilayer structure (1-1) having a configuration of "layer (Y) (0.5 µm)/PET" was obtained.

As a result of measurement of the infrared absorption spectrum of the multilayer structure (1-1), the maximum absorption wavenumber in the region of 800 to 1,400 cm⁻¹ was determined to be 1,107 cm⁻¹, and the half width of the maximum absorption band in the same region was determined to be 37 cm⁻¹. The result is shown in Table 1.

As a result of quantitative analysis of sodium ions contained in the multilayer structure (1-1), the value of {(ionic charge of sodium ions) × (number of moles of sodium ions)}/(number of moles of aluminum ions) was determined to be 0.005. The result is shown in Table 1.

A sample with a size of 21 cm × 30 cm was cut from the multilayer structure (1-1), and this sample was left at 23°C and 50% RH for 24 hours, after which, under the same conditions, the sample was longitudinally stretched by 5% and allowed to keep the stretched state for 10 seconds. The multilayer structure (1-1) subjected to a stretching process was thus prepared. The oxygen transmission rate and moisture permeability of the multilayer structure (1-1) were measured before and after the stretching process. The results are shown in Table 2.

### <Examples 1-2 to 1-23>

Multilayer structures (1-2) to (1-23) of Examples 1-2 to 1-23 were fabricated in the same manner as in the fabrication of the multilayer structure (1-1) of Example 1, except for using the first coating liquids (U-2) to (U-23) instead of the first coating liquid (U-1). As a result of analysis of the metal ion content in the multilayer structure (1-4) of Example 1-4, the value of {(ionic charge of sodium ions) × (number of moles of sodium ions)}/(number of moles of aluminum ions) was determined to be 0.240.

### <Example 1-24>

The first coating liquid (U-4) was applied onto a PET 12 using a bar coater in such a manner that the dry thickness would be 0.5 µm, and the applied film was dried at 110°C for 5 minutes to form a precursor layer of the layer (Y) on the base. The resulting layered product was subsequently heat-treated at 160°C for 1 minute to form the layer (Y). In this way, a multilayer structure having a configuration of "layer (Y) (0.5 µm)/PET" was obtained. The second coating liquid (V-1) was applied onto the layer (Y) of the multilayer structure using a bar coater in such a manner that the dry thickness would be 0.3 µm, and was dried at 200°C for 1 minute to form the layer (W). In this way, a multilayer structure (1-24) of Example 1-24 having a configuration of "layer (W) (0.3 µm)/layer (Y) (0.5 µm)/PET" was obtained.

### <Examples 1-25 to 1-29>

Multilayer structures (1-25) to (1-29) of Example 1-25 to 1-29 were obtained in the same manner as in the fabrication of the multilayer structure (1-24) of Example 1-24, except for using the second coating liquids (V-2) to (V-6) instead of the second coating liquid (V-1).

### <Example 1-30>

A deposited layer (X') of aluminum oxide with a thickness of 0.03 µm was formed on a PET 12 by vacuum deposition. The first coating liquid (U-4) was applied onto this deposited layer using a bar coater in such a manner that the dry thickness would be 0.5 µm, and the applied film was dried at 110°C for 5 minutes to form a precursor layer of the layer (Y) on the base. The resulting layered product was subsequently heat-treated at 180°C for 1 minute to form the layer (Y). In this way, a multilayer structure (1-30) having a configuration of "layer (Y) (0.5 µm)/deposited layer (X') (0.03 µm)/PET" was obtained.

### <Example 1-31>

A deposited layer (X') of aluminum oxide with a thickness of 0.03 µm was formed by vacuum deposition on the layer (Y) of the multilayer structure (1-4) as obtained in Example 1-4, and thus a multilayer structure (1-31) having a configuration of "deposited layer (X') (0.03 µm)/layer (Y) (0.5 pm)/PET (12 µm)" was obtained.

### <Example 1-32>

Deposited layers (X') of aluminum oxide with a thickness of 0.03 µm were formed on both surfaces of a PET 12 by vacuum deposition. The first coating liquid (U-4) was applied onto both of the deposited layers using a bar coater in such a manner that the dry thickness would be 0.5 µm, and the applied films were dried at 110°C for 5 minutes to form precursor layers of the layers (Y). The resulting layered product was subsequently heat-treated using a dryer at 180°C for 1 minute to form the layers (Y). In this way, a multilayer structure (1-32) having a configuration of "layer (Y) (0.5 µm)/deposited layer (X') (0.03 µm)/PET/deposited layer (X') (0.03 µm)/layer (Y) (0.5 µm)" was obtained.

### <Example 1-33>

The first coating liquid (U-4) was applied onto both surfaces of a PET 12 using a bar coater in such a manner that the dry thickness would be 0.5 µm on each surface, and the applied films were dried at 110°C for 5 minutes to form precursor layers of the layers (Y) on the base. The resulting layered product was subsequently heat-treated using a dryer at 180°C for 1 minute to form the layers (Y). Deposited layers (X') of aluminum oxide with a thickness of 0.03 µm were formed on the two layers (Y) of the layered product by vacuum deposition. In this way, a multilayer structure (1-33) having a configuration of "deposited layer (X') (0.03 µm)/layer (Y) (0.5 µm)/PET/layer (Y) (0.5 µm)/deposited layer (X') (0.03 µm)" was obtained.

### <Example 1-34>

A multilayer structure (1-34) of Example 1-34 was obtained in the same manner as in the fabrication of the multilayer structure (1-1) of Example 1-1, except for using the first coating liquid (U-34) instead of the first coating liquid (U-1).

### <Example 1-35>

A multilayer structure (1-35) of Example 1-35 was obtained in the same manner as in the fabrication of the multilayer structure (1-24) of Example 1-24, except for using the first coating liquid (U-34) instead of the first coating liquid (U-1) and the second coating liquid (V-4) instead of the second coating liquid (V-1).

### <Example 1-36>

The first coating liquid (U-36) was applied onto a PET 125 using a bar coater in such a manner that the dry thickness would be 0.3 µm, and was then dried at 110°C for 5 minutes. The drying was followed by heat treatment at 180°C for 1 minute. In this way, a multilayer structure (1-36) was obtained.

### <Examples 1-37 to 1-39>

Multilayer structures (1-37) to (1-39) of Examples 1-37 to 1-39 were obtained in the same manner as in the fabrication of the multilayer structure (1-36) of Example 1-36, except for using the first coating liquids (U-37), (U-34), and (U-39) instead of the first coating liquid (U-36).

### <Comparative Examples 1-1 to 1-6>

Multilayer structures (C1-1) to (C1-6) of Comparative Examples 1-1 to 1-6 were fabricated in the same manner as in the fabrication of the multilayer structure (1-1) of Example 1-1, except for using the first coating liquids (CU-1) to (CU-6) instead of the first coating liquid (U-1). As a result of analysis of the metal ion content in the multilayer structure (C1-1) of Comparative Example 1-1, the content was determined to be less than the lower detection limit, which means that the value of {(ionic charge of sodium ions) × (number of moles of sodium ions)}/(number of moles of aluminum ions) was less than 0.001.

### <Comparative Example 1-7>

A multilayer structure (CA7) of Comparative Example 1-7 was fabricated in the same manner as in the fabrication of the multilayer structure (1-36) of Example 1-36, except for using the first coating liquid (CU-7) instead of the first coating liquid (U-36).

The conditions of formation of the layers (Y) in Examples, the layers (CY) in Comparative Examples which are to be compared with the layers (Y), and the layers (W), are shown in Table 1. The abbreviations in Table 1 refer to the following materials.
PVA: Polyvinyl alcohol (PVA 124, manufactured by KURARAY CO., LTD.)
PAA: Polyacrylic acid (Aron-15H, manufactured by TOAGOSEI CO., LTD.)
PPEM: Poly(2-phosphonooxyethyl methacrylate)
PVPA: Poly(vinylphosphonic acid)

**[Table 1]**

| | Base (X) | Layer (Y) | | | | | | | Layer (W) | | | Maximum absorption wavenumber (cm⁻¹) |
|---|---|---|---|---|---|---|---|---|---|---|---|---|
| | | Coating liquid (U) No. | Cations (Z) | Phosphorus compound (B) | Polymer (C) | F_{Z} × N_{Z}/N_{M} | N_{M}/N_{P} | F_{Z} × N_{Z}/N_{P} | Coating liquid (V) No. | Polymer (G1) | Polymer (G2) | |
| Example 1-1 | PET 12 | U-1 | Na⁺ | Phosphoric acid | PVA | 0.005 | 1.15 | 0.0058 | - | - | - | 1,107 |
| Example 1-2 | PET 12 | U-2 | Na⁺ | Phosphoric acid | PVA | 0.280 | 1.15 | 0.3220 | - | - | - | 1,107 |
| Example 1-3 | PET 12 | U-3 | Na⁺ | Phosphoric acid | PVA | 0.050 | 1.15 | 0.0575 | - | - | - | 1,108 |
| Example 1-4 | PET 12 | U-4 | Na⁺ | Phosphoric acid | PVA | 0.240 | 1.15 | 0.2760 | - | - | - | 1,107 |
| Example 1-5 | PET 12 | U-5 | Na⁺ | Phosphoric acid | PVA | 0.200 | 1.15 | 0.2300 | - | - | - | 1.108 |
| Example 1-6 | PET 12 | U-6 | Na⁺ | Phosphoric acid | PVA | 0.200 | 1.15 | 0.2300 | - | - | - | 1,107 |
| Example 1-7 | PET 12 | U-7 | Na⁺ | Phosphoric acid | PVA | 0.200 | 1.15 | 0.2300 | - | - | - | 1,107 |
| Example 1-8 | PET 12 | U-8 | Na⁺ | Trimethyl phosphate | PVA | 0.200 | 1.15 | 0.2300 | - | - | - | 1,107 |
| Example 1-9 | PET 12 | U-9 | Na⁺ | Phosphoric acid | PAA | 0.200 | 1.15 | 0.2300 | - | - | - | 1,107 |
| Example 1-10 | PET 12 | U-10 | Li⁺ | Phosphoric acid | PVA | 0.200 | 1.15 | 0.2300 | - | - | - | 1,108 |
| Example 1-11 | PET 12 | U-11 | K⁺ | Phosphoric acid | PVA | 0.200 | 1.15 | 0.2300 | - | - | - | 1,108 |
| Example 1-12 | PET 12 | U-12 | Ca²⁺ | Phosphoric acid | PVA | 0.200 | 1.15 | 0.2300 | - | - | - | 1,108 |
| Example 1-13 | PET 12 | U-13 | Co²⁺ | Phosphoric acid | PVA | 0.200 | 1.15 | 0.2300 | - | - | - | 1,107 |
| Example 1-14 | PET 12 | U-14 | Zn²⁺ | Phosphoric acid | PVA | 0.200 | 1.15 | 0.2300 | - | - | - | 1,108 |
| Example 1-15 | PET 12 | U-15 | Mg²⁺ | Phosphoric acid | PVA | 0.200 | 1.15 | 0.2300 | - | - | - | 1,108 |
| Example 1-16 | PET 12 | U-16 | NH⁴⁺ | Phosphoric acid | PVA | 0.200 | 1.15 | 0.2300 | - | - | - | 1,108 |
| Example 1-17 | PET 12 | U-17 | Na⁺, Ca²⁺ | Phosphoric acid | PVA | 0.200 | 1.15 | 0.2300 | - | - | - | 1,107 |
| Example 1-18 | PET 12 | U-18 | Ca²⁺, Zn²⁺ | Phosphoric acid | PVA | 0.200 | 1.15 | 0.2300 | - | - | - | 1,108 |
| Example 1-19 | PET 12 | U-19 | Na⁺ | Phosphoric acid | PVA | 0.200 | 2.60 | 0.5200 | - | - | - | 1,111 |
| Example 1-20 | PET 12 | U-20 | Na⁺ | Phosphoric acid | PVA | 0.200 | 1.06 | 0.2120 | - | - | - | 1,110 |
| Example 1-21 | PET 12 | U-21 | Na⁺ | Phosphoric acid | PVA | 0.200 | 3.07 | 0.6140 | - | - | - | 1,113 |
| Example 1-22 | PET 12 | U-22 | Na⁺ | Phosphoric acid | PVA | 0.200 | 0.88 | 0.1760 | - | - | - | 1,107 |
| Example 1-23 | PET 12 | U-23 | Na⁺ | Phosphoric acid | PVA | 0.200 | 3.99 | 0.7980 | - | - | - | 1,118 |
| Example 1-24 | PET 12 | U-4 | Na⁺ | Phosphoric acid | PVA | 0.240 | 1.15 | 0.2760 | V-1 | PPEM | - | 1,107 |
| Example 1-25 | PET 12 | U-4 | Na⁺ | Phosphoric acid | PVA | 0.240 | 1.15 | 0.2760 | V-2 | PPEM | PVA | 1,107 |
| Example 1-26 | PET 12 | U-4 | Na⁺ | Phosphoric acid | PVA | 0.240 | 1.15 | 0.2760 | V-3 | PPEM | PAA | 1,107 |
| Example 1-27 | PET 12 | U-4 | Na⁺ | Phosphoric acid | PVA | 0.240 | 1.15 | 0.2760 | V-4 | PVPA | - | 1,107 |
| Example 1-28 | PET 12 | U-4 | Na⁺ | Phosphoric acid | PVA | 0.240 | 1.15 | 0.2760 | V-5 | PVPA | PVA | 1,107 |
| Example 1-29 | PET 12 | U-4 | Na⁺ | Phosphoric acid | PVA | 0.240 | 1.15 | 0.2760 | V-6 | PVPA | PAA | 1,107 |
| Example 1-30 | PET 12 | U-4 | Na⁺ | Phosphoric acid | PVA | 0.240 | 1.15 | 0.2760 | - | - | - | 1,107 |
| Example 1-31 | PET 12 | U-4 | Na⁺ | Phosphoric acid | PVA | 0.240 | 1.15 | 0.2760 | - | - | - | 1,107 |
| Example 1-32 | PET 12 | U-4 | Na⁺ | Phosphoric acid | PVA | 0.240 | 1.15 | 0.2760 | - | - | - | 1,107 |
| Example 1-33 | PET 12 | U-4 | Na⁺ | Phosphoric acid | PVA | 0.240 | 1.15 | 0.2760 | - | - | - | 1,107 |
| Example 1-34 | PET 12 | U-34 | Zn²⁺ | Phosphoric acid | PVA | 0.10 | 1.15 | 0.1150 | - | - | - | 1,107 |
| Example 1-35 | PET 12 | U-34 | Zn²⁺ | Phosphoric acid | PVA | 0.10 | 1.15 | 0.1150 | V-4 | PVPA | - | 1,107 |
| Example 1-36 | PET 125 | U-36 | Mg²⁺ | Phosphoric acid | PVA | 0.26 | 1.15 | 0.2990 | - | - | - | 1,107 |
| Example 1-37 | PET 125 | U-37 | B³⁺ | Phosphoric acid | PVA | 0.50 | 1.15 | 0.5750 | - | - | - | 1,107 |
| Example 1-38 | PET 125 | U-34 | Zn²⁺ | Phosphoric acid | PVA | 0.10 | 1.15 | 0.1150 | - | - | - | 1,107 |
| Example 1-39 | PET 125 | U-39 | Ca²⁺ | Phosphoric acid | PVA | 0.10 | 1.15 | 0.1150 | - | - | - | 1,107 |
| Comp. Example 1-1 | PET 12 | CU-1 | - | Phosphoric acid | PVA | - | 1.15 | - | - | - | - | 1,107 |
| Comp. Example 1 -2 | PET 12 | CU-2 | Na⁺ | Phosphoric acid | PVA | 0.0005 | 1.15 | 0.0006 | - | - | - | 1,108 |
| Comp. Example 1-3 | PET 12 | CU-3 | Na⁺ | Phosphoric acid | PVA | 0.200 | 0.34 | 0.0680 | - | - | - | 1,136 |
| Comp. Example 1-4 | PET 12 | CU-4 | Na⁺ | Phosphoric acid | PVA | 0.200 | 5.77 | 1.1540 | - | - | - | 1,145 |
| Comp. Example 1-5 | PET 12 | CU-5 | Si⁴⁺ | Phosphoric acid | PVA | 0.200 | 1.15 | 0.2300 | - | - | - | 1,107 |
| Comp. Example 1-6 | PET 12 | CU-6 | Na⁺ | Phosphoric acid | PVA | 0.620 | 1.15 | 0.7130 | - | - | - | 1,107 |
| Comp. Example 1-7 | PET 12 | CU-1 | - | Phosphoric acid | PVA | - | 1.15 | | - | - | - | 1,107 |

The multilayer structures of Examples 1-2 to 1-39 and Comparative Examples 1-1 to 1-7 were evaluated in the same manner as the multilayer structure (1-1) of Example 1-1. The configurations of the multilayer structures of Examples and Comparative Examples and the evaluation results are shown in Table 2. In Table 2, "-" indicates that the measurement was not done.

**[Table 2]**

| | Multilayer structure | | Oxygen transmission rate mL/(m²•day•atm) | | Moisture permeability g/(m²•day) | |
|---|---|---|---|---|---|---|
| | No. | Configuration | Before stretching | After stretching | Before stretching | After stretching |
| Example 1-1 | 1-1 | (X)/(Y) | 0.4 | 1.1 | 0.2 | 1.6 |
| Example 1-2 | 1-2 | (X)/(Y) | 0.7 | 1.0 | 0.5 | 1.5 |
| Example 1-3 | 1-3 | (X)/(Y) | 0.3 | 0.9 | 0.2 | 1.3 |
| Example 1-4 | 1-4 | (X)/(Y) | 0.4 | 0.6 | 0.2 | 0.8 |
| Example 1-5 | 1-5 | (X)/(Y) | 0.4 | 0.8 | 0.3 | 1.0 |
| Example 1-6 | 1-6 | (X)/(Y) | 0.4 | 1.2 | 0.3 | 1.5 |
| Example 1-7 | 1-7 | (X)/(Y) | 0.4 | 1.1 | 0.3 | 1.6 |
| Example 1-8 | 1-8 | (X)/(Y) | 0.5 | 1.0 | 0.3 | 1.4 |
| Example 1-9 | 1-9 | (X)/(Y) | 0.4 | 0.9 | 0.3 | 1.3 |
| Example 1-10 | 1-10 | (X)/(Y) | 0.4 | 1.0 | 0.3 | 1.3 |
| Example 1-11 | 1-11 | (X)/(Y) | 0.4 | 0.8 | 0.3 | 0.9 |
| Example 1-12 | 1-12 | (X)/(Y) | 0.4 | 0.9 | 0.3 | 1.3 |
| Example 1-13 | 1-13 | (X)/(Y) | 0.5 | 1.0 | 0.4 | 1.4 |
| Example 1-14 | 1-14 | (X)/(Y) | 0.4 | 1.0 | 0.3 | 1.3 |
| Example 1-15 | 1-15 | (X)/(Y) | 0.4 | 0.9 | 0.3 | 1.4 |
| Example 1-16 | 1-16 | (X)/(Y) | 0.4 | 0.8 | 0.3 | 1.5 |
| Example 1-17 | 1-17 | (X)/(Y) | 0.4 | 0.7 | 0.3 | 1.0 |
| Example 1-18 | 1-18 | (X)/(Y) | 0.4 | 0.8 | 0.3 | 1.0 |
| Example 1-19 | 1-19 | (X)/(Y) | 0.7 | 1.1 | 0.8 | 1.4 |
| Example 1-20 | 1-20 | (X)/(Y) | 0.9 | 1.3 | 1.0 | 1.8 |
| Example 1-21 | 1-21 | (X)/(Y) | 0.9 | 1.2 | 1.1 | 1.5 |
| Example 1-22 | 1-22 | (X)/(Y) | 1.0 | 1.4 | 1.2 | 2.0 |
| Example 1-23 | 1-23 | (X)/(Y) | 1.1 | 1.6 | 1.2 | 1.9 |
| Example 1-24 | 1-24 | (X)/(Y)/(W) | 0.4 | 0.5 | 0.2 | 0.5 |
| Example 1-25 | 1-25 | (X)/(Y)/(W) | 0.4 | 0.5 | 0.2 | 0.6 |
| Example 1-26 | 1-26 | (X)/(Y)/(W) | 0.4 | 0.5 | 0.2 | 0.7 |
| Example 1-27 | 1-27 | (X)/(Y)/(W) | 0.4 | 0.5 | 0.2 | 0.4 |
| Example 1-28 | 1-28 | (X)/(Y)/(W) | 0.4 | 0.5 | 0.2 | 0.5 |
| Example 1-29 | 1-29 | (X)/(Y)/(W) | 0.4 | 0.5 | 0.2 | 0.7 |
| Example 1-30 | 1-30 | (X)/(X')/(Y) | < 0.1 | 0.3 | < 0.1 | 0.2 |
| Example 1-31 | 1-31 | (X)/(Y)/(X') | < 0.1 | 0.4 | < 0.1 | 0.3 |
| Example 1-32 | 1-32 | (Y)/(X')/(X)/(X')/(Y) | < 0.1 | 0.1 | < 0.1 | 0.1 |
| Example 1-33 | 1-33 | (X')/(Y)/(X)/(Y)/(X') | < 0.1 | 0.2 | < 0.1 | 0.1 |
| Example 1-34 | 1-34 | (X)/(Y) | 0.3 | 0.8 | 0.2 | 1.1 |
| Example 1-35 | 1-35 | (X)/(Y)/(W) | 0.3 | 0.5 | 0.2 | 0.7 |
| Example 1-36 | 1-36 | (X)/(Y) | - | - | 4.5 × 10⁻³ | - |
| Example 1-37 | 1-37 | (X)/(Y) | - | - | 4.4 × 10⁻³ | - |
| Example 1-38 | 1-38 | (X)/(Y) | - | - | 8.1 × 10⁻³ | - |
| Example 1-39 | 1-39 | (X)/(Y) | - | - | 5.1 × 10⁻³ | - |
| Comp. Example 1-1 | C1-1 | (X)/(CY) | 0.2 | 6.1 | 0.2 | 7.2 |
| Comp. Example 1-2 | C1-2 | (X)/(CY) | 0.2 | 6.0 | 0.2 | 7.0 |
| Comp. Example 1-3 | C1-3 | (X)/(CY) | 5.6 | 8.6 | > 50 | > 50 |
| Comp. Example 1-4 | C1-4 | (X)/(CY) | 4.2 | 9.8 | > 50 | > 50 |
| Comp. Example 1-5 | C1-5 | (X)/(CY) | 0.4 | 6.0 | 0.2 | 7.8 |
| Comp. Example 1-6 | C1-6 | (X)/(CY) | 1.8 | 3.2 | 5.3 | 6.2 |
| Comp. Example 1-7 | C1-7 | (X)/(CY) | - | - | 1.0 × 10⁻² | - |

As is apparent from Table 2, the multilayer structures of Examples successfully maintained both the gas barrier properties and water vapor barrier properties at high levels even when exposed to a high physical stress. The multilayer structures including the layer (W) in addition to the layer (Y) were superior in barrier properties measured after stretching to the multilayer structures including only the layer (Y). The multilayer structure including the layer (W) or the inorganic deposited layer (X') in addition to the layer (Y) was superior in barrier properties measured after stretching to the multilayer structures including only the layer (Y).

### <Example 1-40>

A solar cell module was fabricated using the multilayer structure (1-1) obtained in Example 1-1 as a protective sheet. An amorphous silicon solar cell placed on 10-cm-square tempered glass was sandwiched between two ethylene-vinyl acetate copolymer sheets with a thickness of 450 µm. The multilayer structure (1-1) was then laminated to one of the ethylene-vinyl acetate copolymer sheets that was to receive incident light in such a manner that the polyethylene terephthalate layer of the multilayer structure (1-1) faced outwardly. In this way, the solar cell module was fabricated. The lamination was done by vacuum drawing at 150°C for 3 minutes, followed by compression bonding for 9 minutes. The fabricated solar cell module operated well in air and continued to show good electrical output characteristics over a long period of time.

In Examples and Comparative Examples given below, quantum efficiency and spectral radiant energy were measured with a quantum efficiency measurement apparatus, QE-1000, manufactured by Otsuka Electronics Co., Ltd. The spectral radiant energy was a radiant energy at the fluorescence wavelength of fluorescent quantum dots used in the examples.

### [Fluorescent quantum dot-containing electronic device]

### <Example 2-1>

An amount of 5 g of cycloolefin polymer (ZEONEX (registered trademark) 480 manufactured by Zeon Corporation; amorphous rein containing the structure of the formula [Q-1]) and 5 g of anhydrous toluene (manufactured by Wako Pure Chemical Industries, Ltd.) subjected to freezing and degassing under vacuum followed by storage under argon gas atmosphere were placed in a 50 mL glass screw-cap bottle under argon gas atmosphere and were stirred with a roller stirrer at room temperature to dissolve the cycloolefin polymer in the anhydrous toluene and thus obtain a resin solution 1.

To the obtained resin solution 1 was added, under argon gas atmosphere, 3.05 g of a toluene dispersion of fluorescent quantum dots adjusted in concentration to 82 mg/mL. The fluorescent quantum dots used were nanoparticles prepared using myristic acid as a capping agent and had, as their particle structure, a core-shell structure composed of a core of InP and a shell of ZnS, the core having a diameter of 2.1 nm. The addition of the dispersion was followed by thorough kneading using a planetary centrifugal mixer, ARV310-LED, manufactured by THINKY CORPORATION, thus yielding a dispersion (fluorescent quantum dot-containing composition) 1 containing the fluorescent quantum dots in an amount of 5 mass% relative to the cycloolefin polymer. This dispersion was poured inside a silicone ring (with an outer diameter of 55 mm, an inner diameter of 50 mm, and a thickness of 1 mm) placed on a polymethylpentene petri dish. The dispersion in this state was air-dried under argon gas atmosphere to obtain a sheet-shaped product, which was then dried under nitrogen atmosphere at 40°C for 5 hours to fully remove the solvent. Thus, a fluorescent quantum dot-dispersed resin shaped product 1 was obtained.

To protect the fluorescent quantum dots from air, the multilayer structure (1-1) described in Example 1-1 was then attached to the surface of the fluorescent quantum dot-dispersed resin shaped product 1 using an adhesive resin so that a gas barrier layer was formed. Thus, a fluorescent quantum dot-containing structure 1 was obtained. The thickness of the gas barrier layer was 12.5 µm. The quantum efficiency of the fluorescent quantum dot-containing structure 1 was measured to be 74% using a quantum efficiency measurement apparatus, QE-1000, manufactured by Otsuka Electronics Co., Ltd. This value is comparable to a quantum efficiency of 80% obtained when the same measurement was performed on the toluene dispersion of the fluorescent quantum dots from which the structure was formed.

The fluorescent quantum dot-containing structure 1 was placed over a 22-mW, 450-nm blue LED package, which was caused to emit light in air for 2,000 consecutive hours. The spectral radiant energy of the fluorescent quantum dots measured at the beginning of LED emission was 0.42 mW/nm, while the spectral radiant energy measured after the lapse of 2,000 hours was 0.40 mW/nm. That is, the spectral radiant energy was maintained at a high level corresponding to 95.2% of the initial value after the lapse of 2,000 hours.

### <Example 2-2>

The fluorescent quantum dot-dispersed resin shaped product 1 as obtained in Example 2-1 was processed using a 180°C-heated press machine at a pressing pressure of 20 MPa to obtain a fluorescent quantum dot-containing resin film 1 having a thickness of 100 µm.

To protect the fluorescent quantum dots from air, the multilayer structure (1-1) described in Example 1-1 was then attached to the surface of the fluorescent quantum dot-containing resin film 1 using an adhesive resin so that a gas barrier layer was formed. Thus, a fluorescent quantum dot-containing structure 2 was obtained. The thickness of the gas barrier layer was 12.5 µm.

The structure 2 showed a good quantum efficiency of 76% when it was subjected to the same measurement as in Example 1. The result is shown in Table 3. The structure 2 was subjected also to the same measurement as in Example 2-1. The spectral radiant energy measured at the beginning of emission was 0.39 mW/nm, while the spectral radiant energy measured after the lapse of 2,000 hours was 0.37 mW/nm. That is, the spectral radiant energy was maintained at a high level corresponding to 94.9% of the initial value after the lapse of 2,000 hours.

### <Comparative Example 2>

A fluorescent quantum dot-containing structure 3 was obtained in the same manner as in Example 2-1, except for attaching the multilayer structure described in Comparative Example 1-1 to the surface of the fluorescent quantum dot-dispersed resin shaped product 2 to protect the fluorescent quantum dots from air. The quantum efficiency of the fluorescent quantum dot-containing structure 3 was measured to be 76% using a quantum efficiency measurement apparatus, QE-1000, manufactured by Otsuka Electronics Co., Ltd. This value is comparable to a quantum efficiency of 82% obtained when the same measurement was performed on the toluene dispersion of the fluorescent quantum dots from which the structure was formed.

The fluorescent quantum dot-containing structure 1 was placed over a 22-mW, 450-nm blue LED package, which was caused to emit light in air for 2,000 consecutive hours. The spectral radiant energy of the fluorescent quantum dots measured at the beginning of LED emission was 0.42 mW/nm, while the spectral radiant energy measured after the lapse of 2,000 hours was 0.33 mW/nm. That is, the spectral radiant energy was reduced to 78.5% of the initial value after the lapse of 2,000 hours.

### <Comparative Example 3>

A fluorescent quantum dot-containing structure 4 was obtained in the same manner as in Example 2-1, except for attaching an EVOH film (a 15-pm-thick film fabricated by co-extruding "Soarnol D2908" (trade name) manufactured by The Nippon Synthetic Chemical Industry Co., Ltd.; oxygen transmission rate = 0.5 mL/(m²•day), moisture permeability = 130 g/ m²•24 hrs) to the surface of the fluorescent quantum dot-dispersed resin shaped product 2 to protect the fluorescent quantum dots from air. The quantum efficiency of the fluorescent quantum dot-containing structure 4 was measured to be 76% using a quantum efficiency measurement apparatus, QE-1000, manufactured by Otsuka Electronics Co., Ltd. This value is comparable to a quantum efficiency of 82% obtained when the same measurement was performed on the toluene dispersion of the fluorescent quantum dots from which the structure was formed.

The fluorescent quantum dot-containing structure 1 was placed over a 22-mW, 450-nm blue LED package, which was caused to emit light in air for 2,000 consecutive hours. The spectral radiant energy of the fluorescent quantum dots measured at the beginning of LED emission was 0.42 (mW/nm), while the spectral radiant energy measured after the lapse of 2,000 hours was 0.30 (mW/nm). That is, the spectral radiant energy was reduced to 71.4% of the initial value after the lapse of 2,000 hours.

**[Table 3]**

| | Gas barrier layer | Quantum efficiency (%) | Initial spectral radiant energy (mW/nm) | Spectral radiant energy measured after light emission for 2,000 consecutive hours (mW/nm) | Performance retention (%) |
|---|---|---|---|---|---|
| Example 2-1 | Example 1-1 | 74 | 0.42 | 0.40 | 95.2 |
| Example 2-2 | Example 1-1 | 76 | 0.39 | 0.37 | 94.9 |
| Comp. Example 2 | Comp. Example 1-1 | 76 | 0.42 | 0.33 | 78.5 |
| Comp. Example 3 | EVOH | 76 | 0.42 | 0.30 | 71.4 |

### INDUSTRIAL APPLICABILITY

According to the present invention, it is possible to obtain an electronic device including a protective sheet including a multilayer structure superior in gas barrier properties and water vapor barrier properties and highly resistant to physical stresses. Thus, according to the present invention, it is possible to obtain an electronic device capable of maintaining good properties not only during production and distribution but also during actual use which is often long-lasting. According to the present invention, it is further possible to provide a fluorescent quantum dot-containing electronic device that suffers less reduction in quantum efficiency and can retain its performance at a high level even after long-term use (light emission for 2,000 consecutive hours, for example) in air.

## Claims

1. An electronic device comprising a protective sheet, wherein
the protective sheet comprises a multilayer structure comprising a base (X) and a layer (Y) stacked on the base (X),
the layer (Y) comprises a metal oxide (A), a phosphorus compound (B), and cations (Z) with an ionic charge (F_{Z}) of 1 or more and 3 or less,
the phosphorus compound (B) comprises a compound containing a moiety capable of reacting with the metal oxide (A),
the number of moles (N_{M}) of metal atoms (M) constituting the metal oxide (A) and the number of moles (N_{P}) of phosphorus atoms derived from the phosphorus compound (B) satisfy a relationship of 0.8 ≤ N_{M}/N_{P} ≤ 4.5 in the layer (Y),
the number of moles (N_{M}), the number of moles (Nz) of the cations (Z), and the ionic charge (F_{Z}) satisfy a relationship of 0.001 ≤ F_{Z} × N_{Z}/N_{M} ≤ 0.60 in the layer (Y),
the cations (Z) comprise at least one selected from the group consisting of lithium ions, sodium ions, potassium ions, magnesium ions, calcium ions, titanium ions, zirconium ions, lanthanoid ions, vanadium ions, manganese ions, iron ions, cobalt ions, nickel ions, copper ions, zinc ions, boron ions, aluminum ions, and ammonium ions,
the metal atoms (M) comprise at least one selected from the group consisting of aluminum, titanium, and zirconium,
the layer (Y) comprises a reaction product (D) formed by a reaction between the metal oxide (A) and the phosphorus compound (B), and
in an infrared absorption spectrum of the layer (Y), a maximum absorption wavenumber in a region of 800 to 1,400 cm⁻¹ is 1,080 to 1,130 cm⁻¹.

2. The electronic device according to claim 1, further comprising fluorescent quantum dots.

3. The electronic device according to claim 2, wherein the protective sheet is placed on one side or both sides of a layer containing the fluorescent quantum dots.

4. The electronic device according to any one of claims 1 to 3, wherein the number of moles (N_{M}), the number of moles (N_{Z}), and the ionic charge (F_{Z}) satisfy a relationship of 0.01 ≤ F_{Z} × N_{Z}/N_{M} ≤ 0.60 in the layer (Y).

5. The electronic device according to any one of claims 1 to 4, wherein the phosphorus compound (B) comprises at least one selected from the group consisting of phosphoric acid, polyphosphoric acid, phosphorous acid, phosphonic acid, phosphonous acid, phosphinic acid, phosphinous acid, and derivatives thereof.

6. The electronic device according to any one of claims 1 to 5, wherein the base (X) comprises a thermoplastic resin film.

7. The electronic device according to any one of claims 1 to 6, wherein the layer (Y) comprises a polymer (C) containing at least one functional group selected from the group consisting of a carbonyl group, a hydroxy group, a carboxyl group, a carboxylic anhydride group, and a salt of a carboxyl group.

8. The electronic device according to any one of claims 1 to 7, wherein the multilayer structure further comprises a layer (W) placed contiguous to the layer (Y), and the layer (W) comprises a polymer (G1) having a functional group containing a phosphorus atom.

9. A method for producing the electronic device according to any one of claims 1 to 8, produced by:
a step [I] of mixing a metal oxide (A), a phosphorus compound (B) containing a moiety capable of reacting with the metal oxide (A), and an ionic compound (E) containing cations (Z) with an ionic charge (F_{Z}) of 1 or more and 3 or less, so as to prepare a first coating liquid (U);
a step [II] of applying the first coating liquid (U) onto the base (X) to form a precursor layer of the layer (Y) on the base (X); and
a step [III] of heat-treating the precursor layer at a temperature of 110°C or higher, wherein
the number of moles (N_{M}) of metal atoms (M) constituting the metal oxide (A) and the number of moles (N_{P}) of phosphorus atoms derived from the phosphorus compound (B) satisfy a relationship of 0.8 ≤ N_{M}/N_{P} ≤ 4.5 in the first coating liquid (U),
the number of moles (N_{M}), the number of moles (N_{Z}) of the cations (Z), and the ionic charge (F_{Z}) satisfy a relationship of 0.001 ≤ F_{Z} × N_{Z}/N_{M} ≤ 0.60 in the first coating liquid (U),
the cations (Z) comprise at least one selected from the group consisting of lithium ions, sodium ions, potassium ions, magnesium ions, calcium ions, titanium ions, zirconium ions, lanthanoid ions, vanadium ions, manganese ions, iron ions, cobalt ions, nickel ions, copper ions, zinc ions, boron ions, aluminum ions, and ammonium ions,
the metal atoms (M) comprise at least one selected from the group consisting of aluminum, titanium, and zirconium,
the layer (Y) comprises a reaction product (D) formed by a reaction between the metal oxide (A) and the phosphorus compound (B), and
in an infrared absorption spectrum of the layer (Y), a maximum absorption wavenumber in a region of 800 to 1,400 cm⁻¹ is 1,080 to 1,130 cm⁻¹.

## Patentansprüche

1. Elektronische Vorrichtung, umfassend ein Schutzblatt, wobei das Schutzblatt eine Mehrschichtstruktur, umfassend eine Basis (X) und eine Schicht (Y), angeordnet auf der Basis (X), umfaßt,
die Schicht (Y) ein Metalloxid (A), eine Phosphorverbindung (B) und Kationen (Z) mit einer lonenladung (F_{Z}) von 1 oder mehr und 3 oder weniger umfaßt,
die Phosphorverbindung (B) eine Verbindung, enthaltend eine Einheit, die befähigt ist, mit dem Metalloxid (A) zu reagieren, umfaßt,
die Molzahl (N_{M}) von Metallatomen (M), welche das Metalloxid (A) konstituieren, und die Molzahl (N_{P}) von Phosporatomen, abgeleitet von der Phosphorverbindung (B), eine Gleichung 0,8 ≤ N_{M}/N_{P} ≤ 4,5 in der Schicht (Y) erfüllen,
die Molzahl (N_{M}), die Molzahl (N_{Z}) der Kationen (Z) und die lonenladung (F_{Z}) eine Gleichung 0,001 ≤ F_{Z} x N_{Z}/N_{M} ≤ 0,60 in der Schicht (Y) erfüllen,
die Kationen (Z) mindestens eines, ausgewählt aus der Gruppe, bestehend aus Lithiumionen, Natriumionen, Kaliumionen, Magnesiumionen, Calciumionen, Titanionen, Zirkoniumionen, Lanthanoidionen, Vanadiumionen, Manganionen, Eisenionen, Kobaltionen, Nickelionen, Kupferionen, Zinkionen, Borionen, Aluminiumionen und Ammoniumionen, umfassen,
die Metallatome (M) mindestens eines, ausgewählt aus der Gruppe, bestehend aus Aluminium, Titan und Zirkonium, umfassen,
die Schicht (Y) ein Reaktionsprodukt (D), gebildet durch eine Reaktion zwischen dem Metalloxid (A) und der Phosphorverbindung (B), umfaßt, und
in einem Infrarotabsorptionsspektrum der Schicht (Y) eine Absorptionsmaximumwellenzahl in einem Bereich von 800 bis 1400 cm⁻¹ 1,080 bis 1,130 cm⁻¹ ist.

2. Elektronische Vorrichtung gemäß Anspruch 1, weiter umfassend Fluoreszenzquantendots.

3. Elektronische Vorrichtung gemäß Anspruch 2, wobei das Schutzblatt auf einer Seite oder beiden Seiten einer Schicht, enthaltend die Fluoreszenzquantendots, angeordnet ist.

4. Elektronische Vorrichtung gemäß einem der Ansprüche 1 bis 3, wobei die Molzahl (N_{M}), die Molzahl (N_{Z}) und die lonenladung (F_{Z}) eine Gleichung von 0,01 ≤ F_{Z} x N_{Z}/N_{M} ≤ 0,60 in der Schicht (Y) erfüllen.

5. Elektronische Vorrichtung gemäß einem der Ansprüche 1 bis 4, wobei die Phosphorverbindung (B) mindestens eine, ausgewählt aus der Gruppe, bestehend aus Phosphorsäure, Polyphosphorsäure, phosphoriger Säure, Phosphonsäure, phosphoniger Säure, Phosphinsäure, phosphiniger Säure und Derivate davon umfaßt.

6. Elektronische Vorrichtung gemäß einem der Ansprüche 1 bis 5, wobei die Basis (X) einen thermoplastischen Harzfilm umfaßt.

7. Elektronische Vorrichtung gemäß einem der Ansprüche 1 bis 6, wobei die Schicht (Y) ein Polymer (C), enthaltend mindestens eine funktionale Gruppe, ausgewählt aus der Gruppe, bestehend aus einer Carbonylgruppe, einer Hydroxygruppe, eine Carboxylgruppe, einer Carbonsäureanhydridgruppe und einem Salz einer Carboxylgruppe, umfaßt.

8. Elektronische Vorrichtung gemäß einem der Ansprüche 1 bis 7, wobei die Mehrschichtstruktur weiter eine Schicht (W), angeordnet angrenzend an die Schicht (Y), umfaßt und die Schicht (W) ein Polymer (G1) mit einer funktionalen Gruppe, enthaltend ein Phosphoratom, umfaßt.

9. Verfahren zur Herstellung der elektronischen Vorrichtung gemäß einem der Ansprüche 1 bis 8, hergestellt durch.
einen Schritt [I] des Mischens eines Metalloxids (A), einer Phosphorverbindung (B), enthaltend eine Einheit, die befähigt ist, mit dem Metalloxid (A) zu reagieren, und einer ionischen Verbindung (E), enthaltend Kationen (Z) mit einer lonenladung (F_{Z}) von 1 oder mehr und 3 oder weniger, um derart eine erste Beschichtungsflüssigkeit (U) herzustellen;
einen Schritt [II] des Aufbringens der ersten Beschichtungsflüssigkeit (U) auf die Basis (X) unter Bildung einer Vorläuferschicht der Schicht (Y) auf der Basis (X), und
einen Schritt [III] des Wärmebehandelns der Vorläuferschicht bei einer Temperatur von 110°C oder höher, wobei
die Molzahl (N_{M}) von Metallatomen (M), welche das Metalloxid (A) konstituieren, und die Molzahl (N_{P}) von Phosporatomen, abgeleitet von der Phosphorverbindung (B), eine Gleichung 0,8 ≤ N_{M}/N_{P} ≤ 4,5 in der ersten Beschichtungsflüssigkeit (U) erfüllen,
die Molzahl (N_{M}), die Molzahl (N_{Z}) der Kationen (Z) und die lonenladung (F_{Z}) eine Gleichung 0,001 ≤ F_{Z} x N_{Z}/N_{M} ≤ 0,60 in der ersten Beschichtungsflüssigkeit (U) erfüllen,
die Kationen (Z) mindestens eines, ausgewählt aus der Gruppe, bestehend aus Lithiumionen, Natriumionen, Kaliumionen, Magnesiumionen, Calciumionen, Titanionen, Zirkoniumionen, Lanthanoidionen, Vanadiumionen, Manganionen, Eisenionen, Kobaltionen, Nickelionen, Kupferionen, Zinkionen, Borionen, Aluminiumionen und Ammoniumionen, umfassen,
die Metallatome (M) mindestens eines, ausgewählt aus der Gruppe, bestehend aus Aluminium, Titan und Zirkonium, umfassen,
die Schicht (Y) ein Reaktionsprodukt (D), gebildet durch eine Reaktion zwischen dem Metalloxid (A) und der Phosphorverbindung (B), umfaßt, und
in einem Infrarotabsorptionsspektrum der Schicht (Y) eine Absorptionsmaximumwellenzahl in einem Bereich von 800 bis 1400 cm⁻¹ 1,080 bis 1,130 cm⁻¹ ist.

## Revendications

1. Dispositif électronique comprenant une feuille protectrice, dans lequel la feuille protectrice comprend une structure multicouche comprenant une base (X) et une couche (Y) empilée sur la base (X),
la couche (Y) comprend un oxyde métallique (A), un composé de phosphore (B) et des cations (Z) avec une charge ionique (F_{Z}) de 1 ou plus et de 3 ou moins, le composé de phosphore (B) comprend un composé contenant une fraction capable de réagir avec l'oxyde de métal (A),
le nombre de moles (N_{M}) d'atomes de métal (M) constituant l'oxyde de métal (A) et le nombre de moles (N_{P}) d'atomes de phosphore dérivés du composé de phosphore (B) satisfont à une relation 0,8 ≤ N_{M}/N_{P} ≤ 4,5 dans la couche (Y),
le nombre de moles (N_{M}), le nombre de moles (N_{z}) des cations (Z) et la charge ionique (F_{Z}) satisfont à une relation de 0,001 ≤ F_{Z} x Nz/N_{M} ≤ 0,60 dans la couche (Y),
les cations (Z) comprennent au moins l'un sélectionné parmi le groupe consistant en ions lithium, ions sodium, ions potassium, ions magnésium, ions calcium, ions titane, ions zirconium, ions lanthanoïde, ions vanadium, ions manganèse, ions fer, ions cobalt, ions nickel, ions cuivre, ions zinc, ions bore, ions aluminium et ions ammonium,
les atomes de métal (M) comprennent au moins l'un sélectionné parmi le groupe consistant en aluminium, titane et zirconium,
la couche (Y) comprend un produit réactionnel (D) formé par la réaction entre l'oxyde de métal (A) et le composé de phosphore (B), et
dans un spectre d'absorption de l'infrarouge de la couche (Y), un nombre d'ondes d'absorption maximum dans une région de 800 à 1.400 cm⁻¹ va de 1.080 à 1.130 cm⁻¹.

2. Dispositif électronique selon la revendication 1, comprenant en outre des points quantiques fluorescents.

3. Dispositif électronique selon la revendication 2, dans lequel la feuille protectrice est placée sur un côté, ou sur les deux côtés, d'une couche contenant les points quantiques fluorescents.

4. Dispositif électronique selon l'une quelconque des revendications 1 à 3, dans lequel le nombre de moles (N_{M}), le nombre de moles (N_{z}) et la charge ionique (F_{Z}) satisfont à une relation de 0,01 ≤ F_{Z} x N_{z}/N_{M} ≤ 0,60 dans la couche (Y).

5. Dispositif électronique selon l'une quelconque des revendications 1 à 4, dans lequel le composé de phosphore (B) comprend au moins l'un sélectionné parmi le groupe consistant en acide phosphorique, acide polyphosphorique, acide phosphoreux, acide phosphonique, acide phosphoneux, acide phosphinique, acide phosphineux et des dérivés de ceux-ci.

6. Dispositif électronique selon l'une quelconque des revendications 1 à 5, dans lequel la base (X) comprend un film de résine thermoplastique.

7. Dispositif électronique selon l'une quelconque des revendications 1 à 6, dans lequel la couche (Y) comprend un polymère (C) contenant au moins un groupement fonctionnel sélectionné parmi le groupe consistant en un groupement carbonyle, un groupement hydroxy, un groupement carboxyle, un groupement anhydride carboxylique et un sel d'un groupe carboxyle.

8. Dispositif électronique selon l'une quelconque des revendications 1 à 7, dans lequel la structure multicouche comprend en outre une couche (W) placée contiguë à la couche (Y), et la couche (W) comprend un polymère (G1) ayant un groupement fonctionnel contenant un atome de phosphore.

9. Procédé de production du dispositif électronique selon l'une quelconque des revendications 1 à 8, produit par:
une étape [I] où l'on mélange un oxyde de métal (A), un composé de phosphore (B) contenant une fraction capable de réagir avec l'oxyde de métal (A) et un composé ionique (E) contenant des cations (Z) avec une charge ionique (F_{Z}) de 1 ou plus et de 3 ou moins, de manière à préparer un premier liquide de revêtement (U);
une étape [II] où l'on applique le premier liquide de revêtement (U) sur la base (X) pour former une couche de précurseur de la couche (Y) sur la base (X); et
une étape [III] où l'on traite thermiquement la couche de précurseur à une température de 110°C ou plus, dans lequel:
le nombre de moles (N_{M}) d'atomes de métal (M) constituant l'oxyde de métal (A) et le nombre de moles (N_{P}) d'atomes de phosphore dérivés du composé de phosphore (B) satisfont à une relation 0,8 ≤ N_{M}/N_{P} ≤ 4,5 dans le premier liquide de revêtement (U),
le nombre de moles (N_{M}), le nombre de moles (N_{z}) des cations (Z) et la charge ionique (Fz) satisfont à une relation de 0,001 ≤ F_{Z} x N_{z}/N_{M} ≤ 0,60 dans le premier liquide de revêtement (U),
les cations (Z) comprennent au moins l'un sélectionné parmi le groupe consistant en ions lithium, ions sodium, ions potassium, ions magnésium, ions calcium, ions titane, ions zirconium, ions lanthanoïde, ions vanadium, ions manganèse, ions fer, ions cobalt, ions nickel, ions cuivre, ions zinc, ions bore, ions aluminium et ions ammonium,
les atomes de métal (M) comprennent au moins l'un sélectionné parmi le groupe consistant en aluminium, titane et zirconium,
la couche (Y) comprend un produit réactionnel (D) formé par la réaction entre l'oxyde de métal (A) et le composé de phosphore (B), et
dans un spectre d'absorption de l'infrarouge de la couche (Y), un nombre d'ondes d'absorption maximum dans une région allant de 800 à 1.400 cm⁻¹ va de 1.080 à 1.130 cm⁻¹.
